(19) **Europäisches Patentamt** / **European Patent Office** / **Office européen des brevets**

(11) **EP 3 618 130 B1**

(12) **EUROPEAN PATENT SPECIFICATION**

(45) Date of publication and mention
of the grant of the patent:
**26.07.2023 Bulletin 2023/30**

(21) Application number: **18382629.6**

(22) Date of filing: **29.08.2018**

(51) International Patent Classification (IPC):
**H05B 33/12** *(2006.01)*   **H05B 33/14** *(2006.01)*
**H10K 50/10** *(2023.01)*

(52) Cooperative Patent Classification (CPC):
**C09K 11/661; H05B 33/14; H05B 33/20;
H10K 50/115**

(54) **A LIGHT EMITTING DEVICE, AN OPTICAL SPECTROMETER, AND A DOWN-CONVERTING FILM FOR A LIGHT EMITTING DEVICE**

LICHTEMITTIERENDE VORRICHTUNG, EIN OPTISCHES SPEKTROMETER UND EIN ABWÄRTS KONVERTIERENDER FILM FÜR EINE LICHTEMITTIERENDE VORRICHTUNG

DISPOSITIF ÉMETTEUR DE LUMIÈRE, SPECTROMÈTRE OPTIQUE ET FILM DE CONVERSION DESTINÉ À UN DISPOSITIF ÉMETTEUR DE LUMIÈRE

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(43) Date of publication of application:
**04.03.2020 Bulletin 2020/10**

(73) Proprietors:
• **Fundació Institut de Ciències Fotòniques
08860 Castelldefels (Barcelona) (ES)**
• **Institució Catalana De Recerca I
Estudis Avançats (ICREA)
08010 Barcelona (ES)**

(72) Inventors:
• **KONSTANTATOS, Gerasimos
08860 Castelldefels (ES)**
• **PRADHAN, Santanu
08860 Castelldefels (ES)**

(74) Representative: **Ponti & Partners, S.L.P
Edifici PRISMA
Av. Diagonal núm. 611-613, Planta 2
08028 Barcelona (ES)**

(56) References cited:
**US-A1- 2010 270 511     US-A1- 2011 284 819
US-A1- 2018 019 371**

• **CHIN, P.T.K.; HIKMET, R.A.M.; MESKERS, S.C.J.; JANSSEN, R.A.J.: "Energy Transfer and Polarized Emission in Cadmium Selenide Nanocrystal Solids with Mixed Dimensionality", ADVANCED FUNCTIONAL MATERIALS, vol. 17, no. 18, 17 December 2007 (2007-12-17), pages 3829-3835, XP055603334, DE ISSN: 1616-301X, DOI: 10.1002/adfm.200700683**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

**Description**

FIELD OF THE INVENTION

The present invention generally relates to a light emitting device (LED), and more particularly to a highly efficient and low cost light emitting device, that is suitable for emitting visible light and also infrared light including near and short-wave infrared light.

Further aspects of the invention refer to a spectrometer comprising the LED of the invention, and to a down-converting film for a LED.

BACKGROUND OF THE INVENTION

Colloidal quantum dots (COOs) have been established as one of the most promising optoelectronic material platform serving applications related to photodetection [1], photovoltaics [2,3] and light emission [4,5,6], in view of their solution-processability, broadband bandgap tunability and favourable optoelectronic properties [7]. CQD light emitting diodes (LEDs) with compelling performance, based on Cd-chalcogenide systems, have been reported in the visible part of spectrum [8,9], and have successfully reached commercialization. Yet infrared emitting COOs, mainly based on Pb-chalcogenides, currently underperform their visible emitting counterparts, largely limited by their low photoluminescence quantum efficiency (PLQE) [10].

Near and short-wave infrared (NIR, SWIR) light emitting diodes serve a rather broad range of applications, including night vision [11], surveillance [12], remote sensing [13], biological imaging [14] and spectroscopy [15]. Recent progress in on-chip and wearable infrared spectroscopy for quality inspection, health and process monitoring also requires the development of highly efficient, CMOS-compatible and low cost NIR and SWIR LEDs [16,17,18]. In contrast to other highly performant solution processed materials such as polymers and dyes, whose bandgaps are mainly limited in the visible, COOs offer a unique opportunity as they readily provide access to the infrared part of spectrum [7]. In view of this, several efforts have been made to develop highly efficient CQD infrared-emitting LEDs [10,19,20,21,22,23]. One fundamental determinant factor of a diode's external quantum efficiency (EQE), defined as the ratio of the number of emitted photons over the number of injected electric carriers is the PLQE. Prior reports on infrared CQD LEDs have considered the use of core-shell CQD structures [10], inspired by the case of visible emitting CQDs, reaching EQE in excess of 4%. Alternatively, the use of appropriate host matrices has been considered as a means to suppress PLQE quenching in close-packed COOs due to energy transfer. Initial reports have employed polymer host matrices [24,25,26,27], yet with limited EQEs mainly due to the polymers' poor electron transport properties. Recently, an alternative matrix has been reported based on perovskite materials epitaxially connected to the CQD emitting species serving both as a chemical passivant of the QD surface and as an efficient carrier transport matrix, leading to EQE of 5.2% and power conversion efficiency (PCE) of 4.9% [21]. PCE in LEDs is defined as the ratio of optical output power over the electrical input power and it is of paramount importance when considering the power consumption of the device.

EP2212398B1 discloses a light emitting device comprising the following features:

- a substrate;
- a first electrode formed by a first electrically conductive layer arranged over said substrate;
- an active light emitting layer arranged over said first electrically conductive layer, and that comprises a host matrix and light emitting quantum dots embedded there within; and
- a second electrode formed by a second electrically conductive layer arranged over said active light emitting layer.

US 2010/270511 A1 discloses a light emitting device comprising the features included in the preamble of claim 1. The host matrix disclosed in US 2010/270511 A1 comprises a matrix made of quantum dots.

The host matrix of the device disclosed in EP2212398B1 is a semiconductor matrix made of nanoparticles that are not quantum dots, and offers a quantum efficiency that is clearly improvable.

It is, therefore, necessary to provide an alternative to the state of the art which covers the gaps found therein, by providing a light emitting device that offers a much higher efficiency than the devices known in the prior art, in terms of quantum efficiency (external and internal) and power conversion efficiency, and a high radiance.

SUMMARY OF THE INVENTION

To that end, the present invention relates, in an aspect, to a light emitting device (LED), comprising an optoelectronic device comprising, in a known manner:

- a substrate;

- a first electrode formed by a first electrically conductive layer arranged over said substrate;
- an active light emitting layer arranged over said first electrically conductive layer, and that comprises a host matrix and light emitting quantum dots embedded there within; and
- a second electrode formed by a second electrically conductive layer arranged over said active light emitting layer.

In contrast to the light emitting devices known in the prior art, in the light emitting device of the present invention, in a characterizing manner, the host matrix comprises charge carrier supplier quantum dots blended with said light emitting quantum dots, forming a binary blend where the charge carrier supplier quantum dots are made and arranged to supply charge carriers to the light emitting quantum dots, and wherein the light emitting quantum dots are made and arranged to accept the supplied charge carriers.

Although the light emitting device of the present invention is made to emit light of any wavelength, for some preferred embodiments the device is made to emit infrared, near infrared and/or short-wave infrared light.

For an embodiment of the light emitting device of the present invention, the host matrix comprises a ternary blend formed by the above mentioned binary blend and further quantum dots made and arranged to passivate electronically possible electron traps of the light emitting quantum dots and to balance charge carrier injection.

The above mentioned charge carrier supplier quantum dots are, for an embodiment, smaller than the light emitting quantum dots, have a larger bandgap and form a type-I heterojunction therewith.

With respect to the above mentioned further quantum dots, for an embodiment, they have a bandgap that is larger than that of the charge carrier supplier quantum dots, and a band alignment with respect to the bands of the charge carrier supplier quantum dots and light emitting quantum dots that favours injection of electrons or holes in the light emitting quantum dots, but not both, forming a type-I heterojunction therewith.

For some embodiments, the concentration of the light emitting quantum dots in the binary or ternary blend ranges from 1% up to 20% by volume, and the concentration of the charge carrier supplier quantum dots in the binary or ternary blend ranges from 80% up to 99% in volume, preferably from 50% up to 99% by volume.

Regarding the concentration of the further quantum dots in the ternary blend, according to some embodiments, it ranges between 20% and 50% by volume, preferably from 30% up to 50%.

According to a preferred embodiment, the host matrix forms an electrically conductive percolating path, while the light emitting quantum dots are dispersed within the host matrix so distanced and isolated from each other that they do not form any electrically conductive path.

According to the present invention the light emitting quantum dots are homogeneously dispersed within the host matrix and distanced above 3 nm from each other.

For an embodiment, the charge carrier supplier quantum dots possess carrier diffusion lengths larger than 10 nm for both types of charge carriers, electrons and holes, preferably in a range from 10 nm up to 500 nm.

For preferred embodiments, the light emitting device of the present invention further comprises:

- an electron injecting and hole blocking layer arranged between said active light emitting layer and one of said first and second electrodes; and
- a hole injecting and electron blocking layer arranged between said active light emitting layer and the other of said first and second electrodes.

For an embodiment, the light emitting device of the present invention is a bottom emitting device, where the substrate and the one of the above mentioned electron injecting and hole blocking layer and hole injecting and electron blocking layer which is arranged between the active light emitting layer and the first electrode are transparent to a wavelength range of illumination of the light emitting device, while a reflective layer (such as the electron injecting and hole blocking layer or the hole injecting and electron blocking layer which is arranged between the active light emitting layer and the second electrode) is placed between the active light emitting layer and the second electrode. Preferably, the first electrode is also transparent to said wavelength range.

For an alternative embodiment, the light emitting device of the present invention is a top emitting device, where the one of the above mentioned electron injecting and hole blocking layer and hole injecting and electron blocking layer which is arranged between the active light emitting layer and the second electrode are transparent to a wavelength range of illumination of the light emitting device, while a reflective layer (such as the electron injecting and hole blocking layer or the hole injecting and electron blocking layer which is arranged between the active light emitting layer and the first electrode) is placed between the active light emitting layer and the first electrode. Preferably, the second electrode is also transparent to said wavelength range, while the substrate is not necessarily transparent.

For an embodiment, the electron injecting and hole blocking layer is arranged between the active light emitting layer and the first electrode, and the hole injecting and electron blocking layer is a semiconductor layer that forms a type-II heterojunction with all of the quantum dots of the active light emitting layer.

For an implementation of said embodiment, the hole injecting and electron blocking semiconductor layer comprises quantum dots.

Both the charge carrier supplier quantum dots and the light emitting quantum dots are PbS quantum dots, for an embodiment.

According to an embodiment, the further quantum dots are ZnO nanocrystals.

The quantum dots of the different layers of the LED of the present invention are generally colloidal quantum dots

For further aspects of the invention, instead of a LED, a photodetector and a solar cell are proposed which differ structurally with the LED of the present invention basically in that the above referred as active light emitting layer is an active light absorbing layer much thicker than the active light emitting layer of the LED.

A further aspect of the present invention relates to an optical spectrometer that comprises the light emitting device of the present invention and at least one photodetector made to detect light with any of the wavelengths that the light emitted by the light emitting device has.

The spectrometer of the present invention is configured for emitting light, by means of the light emitting device, with different wavelengths onto an object, and the at least one photodetector is made to detect light with any of said different wavelengths once reflected or transmitted from the object.

For a preferred embodiment, the at least one photodetector is based on quantum dots, CMOS compatible, and monolithically integrated with the light emitting device into a common chip.

For an embodiment, the at least one photodetector of the spectrometer is a hybrid graphene-QDs photodetector or a QD photodiode.

For an embodiment, the optical spectrometer of the present invention comprises a pixelated LED array of LEDs as described above wherein each one of those employ emitting QDs of different size thereby offering spectral luminescence in different wavelengths that can be separated from each other from 20 nm up to 200 nm, to allow for spectroscopy function. In this configuration, the LEDs of the array are excited sequentially and the at least one photodetector of the spectrometer records the reflected/transmitted signal from the object under spectroscopic test for each excitation wavelength. In an improvement of this embodiment narrowband bandpass filters in front of the LEDs are used to enhance the spectral resolution of the LEDs. In this scenario the bandpass zone of the filter(s), in nm, is smaller than that of the FWHM (Full Width at Half Maximum) of the LED, allowing the resolution of the spectrometer to be determined by that of the bandpass filters and not by that of the LEDs.

In a different embodiment, the LED array is excited simultaneously providing a broadband response of light that comprises the superposition of the light emitting spectra of the LEDs and in the detection part there is an array of photodetectors each one of which is covered by an appropriate bandpass filter so that each photodetector of the array yields a signal from that received by the reflected or transmitted light from the object under test, within the spectral band of the bandpass filter covering the respective photodetector.

In both spectrometer embodiments, appropriate optics should be included comprising lens systems that focus the excitation light from the LEDs to the object under test, and collection optics also exist to collect the reflected/transmitted light from the object under test to the photodetectors.

A further aspect of the present invention relates to a down-converting film for a LED, where the down-converting film comprises the above described active light emitting layer and is configured and arranged to be placed atop said LED to absorb and down convert light emitted thereby, i.e. to emit light at longer wavelengths.

For an embodiment, the down-converting film is made to absorb visible light and provide broadband illumination in the visible and SWIR wavelength range.

All the embodiments describing above the composition and arrangement of the active light emitting layer are valid for describing corresponding embodiments of the down-converting film of the present invention.

In a still further aspect, the present invention also relates to a nanocomposite comprising at least the above described active light emitting layer.

For an embodiment, the nanocomposite also comprises the above mentioned electron injecting and hole blocking layer and the hole injecting and electron blocking layer, sandwiching the active light emitting layer.

All the embodiments describing above the composition and arrangement of the electron injecting and hole blocking layer, the active light emitting layer, and the hole injecting and electron blocking layer of the LED of the present invention, are valid for describing corresponding embodiments of the nanocomposite of the present invention.

BRIEF DESCRIPTION OF THE FIGURES

In the following some preferred embodiments of the invention will be described with reference to the enclosed figures. They are provided only for illustration purposes without however limiting the scope of the invention.

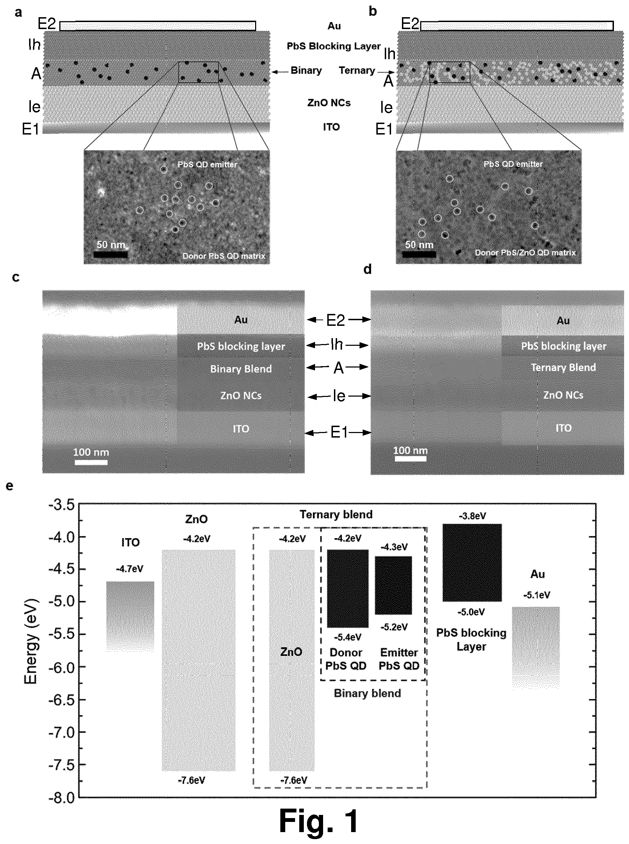

Figure 1: Structure and composition of the light emitting device of the present invention for an embodiment for which the active light emitting layer is formed by a binary blend of quantum dots (a) and an embodiment for which it is formed by a ternary blend of quantum dots. TEM images of ligand treated binary and ternary blends respectively that comprise the active light emitting layer of the corresponding LEDs are shown as well. Circular white markers show the emitter QDs in donor matrix. c,d. FIB SEM cross-sectional images of binary (c) and ternary (d) blend based LED devices. e. Energy level diagram of the materials that constitute the LED devices. The energy values are taken from UPS measurements.

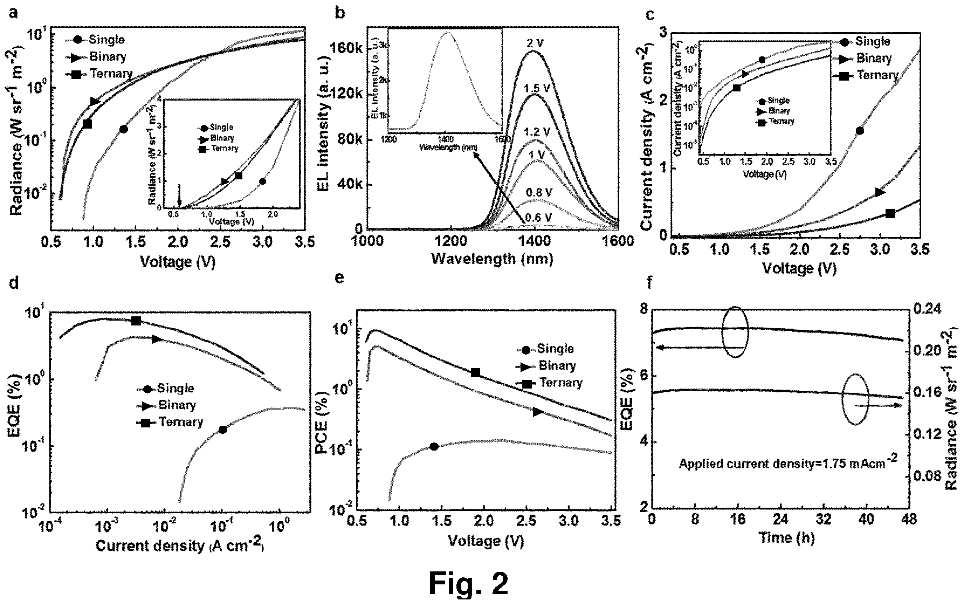

Figure 2: Performance of the LED device of the present invention for two embodiments identified as "binary" and "ternary" (blends of QDs) and of a prior art LED device identified as "single" (blend of QDs). a. Radiance of the devices with applied voltage bias. Inset shows the radiance in linear scale to indicate the turn-on voltage. The depicted arrow shows the low turn-on voltage of 0.6 V in case of binary and ternary blends devices. b. EL spectra of ternary blend device with different applied bias voltage. Inset shows the zoomed EL spectra with 0.6 V applied bias. Strong sub-bandgap emission is observed in the devices. c. Injection current density is plotted as a function of applied bias. Inset shows the logarithmic plot to indicate the gradual suppression of leakage current from single to binary and further to ternary blend devices. d. EQE of the devices are plotted against injected current. e. PCE of the devices with applied voltage bias. f. Stability test of the champion device. The radiance and EQE of the device are observed with a constant applied current density of 1.75 mA cm-2 over a period of 48 hours.

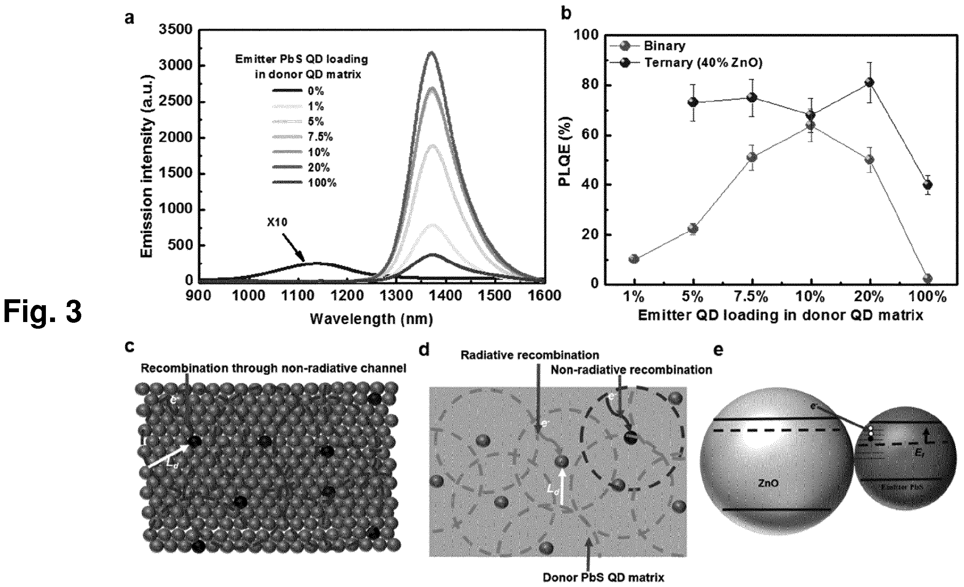

Figure 3: PL and PLQE of QD blends. a. Evolution of PL spectra with different emitter QD loading in donor QD matrix. The loading of emitter QD completely quench the PL emission from the donor matrix and enhance the emitter QD band-edge PL intensity. b. PLQE of binary and ternary QD blends with different emitter QD loading in donor QD matrix. For ternary mixing, 40% ZnO NCs mixed with different binary blends. c,d. Schematic diagram of charge recombination in emitter only QD arrays (c) and emitter QDs in donor QD matrix (d). The black spheres represents the defective QDs in arrays (as channels for non-radiative recombination). The charge collection zone of defective QDs determined by the carrier diffusion length (Ld) are shown as dark grey dashed circles around the QDs. (d) By loading emitter QDs in a donor QD matrix, the number of non-radiative recombination channels per volume decrease and radiative recombination channels increase through charge transfer from donor QDs to emitter QDs (light grey dashed circles). e. The schematic representation of remote trap passivation of PbS QDs through electron transfer from ZnO NCs. The empty traps (white circles) are filled by the electrons of the n-type ZnO NCs.

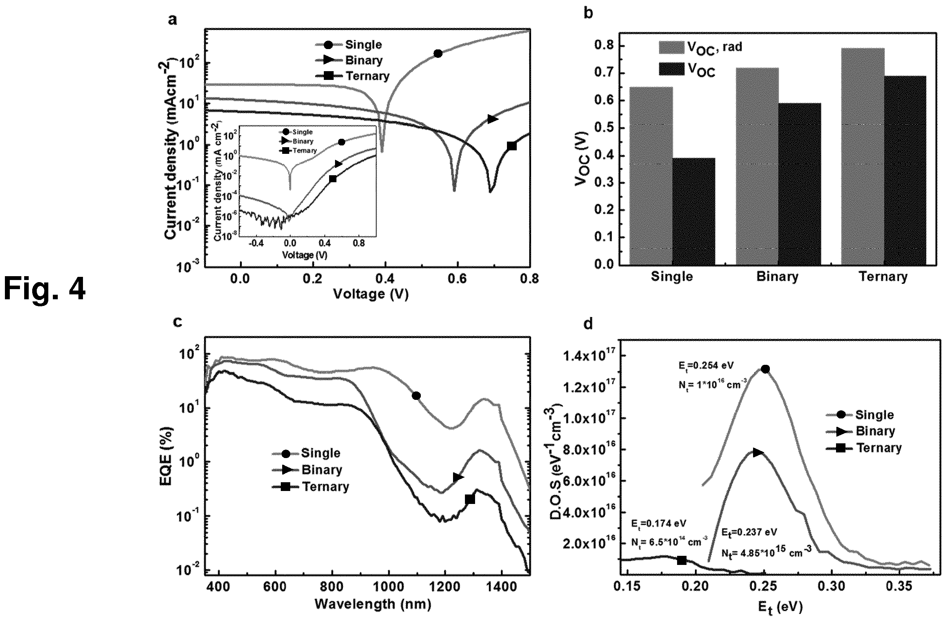

Figure 4: Photovoltaic performance and quantified trap-state analysis via TAS of the single (prior art), binary and ternary (present invention) QD blend devices. a. J-V plot under AM1.5 simulated irradiation of the three devices under study. The VOC of the devices increases from single to binary blend and further to ternary blend. Inset shows the dark J-V plot of PV devices. Decrease of reverse saturation current is observed in accordance with the VOC evolution from single to ternary blend devices. b. Radiative VOC limit estimation by calculating luminescence EQE of PV device at an applied voltage of VOC. Decrease of non-radiative VOC losses observed from single to binary device and further to ternary device, c. EQE of PV devices based on single, binary and ternary QDs. d. Quantification of density of in-gap trap states from TAS analysis. Binary blend shows reduced traps with slight decrease of trap energy (Et). Ternary blend shows significant decrease of traps as well as Et as a result of trap passivation.

Figure 5: Peak EQE statistics for ternary blend based devices. A total of 23 working devices were considered for the statistics. The variation of emitting QD wavelength for different device is within $\pm 10$ nm.

Figure 6: (a) Radiance and (b) EQE plot for MPA (3-Mercaptopropionic Acid) treated ternary blend based LED. High turn-on (~2.5 V) and much lower EQE indicate lower mobility and charge transport with only MPA treatment compared to the mixed ligand treatments.

Figure 7: Electroluminescence (EL) spectra of ternary devices based on (a) different emitter QDs in similar donor matrix and (b) same emitter QDs in different donor matrix.

Figure 8: Peak EQE of the binary devices with different emitter QD loading.

Figure 9: PLQE of ternary devices with different binary blend combinations and ZnO nc loading.

Figure 10 Peak EQE of the LED devices based on the different ZnO nc loading in 7.5% emitter QD based binary blend.

Figure 11 PL spectra of single, binary and ternary blends. Loading of QDs does not modify the spectral shape drastically.

Figure 12 Internal quantum efficiency (IQE) of single, binary and ternary devices calculated using a previously reported method1. The combined refractive index of ZnO, ITO and glass was taken as 1.45. The ternary blend based device showed a record peak 33% IQE for IR LEDs.

Figure 13: Luminescent EQE of single, binary, ternary blend based PV devices.

Figure 14: Frequency dependent capacitance plot for (a) single, (b) binary and (c) ternary devices.

Figure 15: (-fdC/df) vs frequency plots to estimate the turn-over frequency (resonance frequency) for (a) single, (b) binary, and (c) ternary devices.

Figure 16: The Arrhenius plot of $f_0 T^{-2}$ yields the activation energy (EA) from the temperature dependent c-f plot. The slope of the plot gives the activation energy of the single binary and ternary blend devices.

Figures 17a, 17b and 17c schematically show three respective embodiments of the spectrometer of the present invention and associated operations thereof.

DESCRIPTION OF THE PREFERRED EMBODIMENTS

In contrast to prior reports, the present inventors posit that instead of relying solely on chemical passivation of the CQD emitting species, the use of a remote charge passivation mechanism induced from an appropriate matrix would be more robust and efficient in reducing trap state density in the CQDs [28,29]. Unlike prior approaches [21,26], the present invention is based entirely on CQD materials. In doing so, the present invention exploits the advances made in QD solids in terms of mobility and carrier diffusion length thanks to the progress in photovoltaic devices [30,31,32], in which mobilities and carrier diffusion lengths in excess of $\sim 10^{-2}$ cm$^2$ V$^{-1}$ s$^{-1}$ and 230 nm respectively, have been reported, fulfilling the needs for efficient carrier transport in the typical thinner-than-solar-cells, LED devices.

Two main embodiments have been proposed for the light emitting device of the present invention, corresponding to two LED architectures, and are described in the present section for some specific materials for the different layers of the device which has been built and tested by the present inventors, according to two corresponding embodiments, i.e. two prototypes have been built. However, although not described in the present section, other alternative materials (for example for the QDs of the active light emitting layer) are also possible and covered by the present invention, as long as they are appropriate for implementing the present invention, as defined in the attached claims.

As shown in Figure 1 (a, b, c, and d), the device of the present invention comprises:

- a first electrode E1 formed by a first electrically conductive layer arranged over a substrate (not shown);
- an electron injecting and hole blocking layer Ie arranged between the active light emitting layer and the first electrode E1;
- an active light emitting layer A arranged over the first electrically conductive layer, and that comprises a host matrix and light emitting quantum dots embedded there within;
- a hole injecting and electron blocking layer Ih arranged between the active light emitting layer A and the second electrode E2; and
- a second electrode E2 formed by a second electrically conductive layer arranged over said active light emitting layer.

For one of the two illustrated embodiments (Figure 1a,c) the active light emitting layer A of the LED comprises a binary blend of small PbS QDs with large bandgap serving as the carrier supplier for the large PbS QDs with smaller-bandgap that act as the carrier acceptor and emitting species, and for the other illustrated embodiment (Figure 1b,d) the active light emitting layer A comprises a ternary blend formed by the binary blend with the addition of ZnO nanocrystals (NCs), which serve as a high-bandgap electron-rich transporting medium and that is employed to further balance carrier injection in the active region as well as to further passivate remotely the traps of the PbS QDs [28].

The ligand exchange scheme that was employed for the active light emitting layers A was based on a mixture of zinc iodide and 3-mercapto-propionic-acid (MPA) as it has delivered previously solar cells with long carrier diffusion lengths and high open circuit voltage [33] (see "Methods" sub-section below for the details of device fabrication). Both structures also employ a ZnO front layer (Ie) as an electron injection, hole-blocking layer and 1, 2-Ethanedithiol (EDT) treated small PbS QD layer (Ih) on top that facilitates hole injection and electron blocking at the back interface. The thickness of each of the layers used in high performance devices considered in the built prototypes are illustrated in the cross/sectional focused ion beam SEM images in Fig. 1c,d for the binary and ternary blends respectively. Typically, the optimal thickness of electron injecting (Ie), active (A) and hole (Ih) injecting layers are around 80 nm, 60 nm and 70 nm respectively. The TEM images of Fig. 1 illustrate the effective blending of these QD species at the nanoscale and support the nature of the nanocomposite active layer A. The corresponding band diagrams of the constituent materials used in these devices are shown in Fig. 1e, taken from UV photoelectron spectroscopy measurements (UPS). According to this, both ZnO NCs and small PbS QDs serve as a type-I heterostructure with the emitting large PbS QDs. The small PbS QD matrix forms a marginal type-I heterostructure with the large PbS QD emitters in which the band offset confinement for both electrons and holes is between 0.1-0.2 eV. Based on the band diagram electron transport and injection takes place within the ZnO NC and the small PbS QD matrix given their matched conduction band levels, whereas hole transport is facilitated largely via the small PbS QD matrix.

Figure 2a shows the radiance of the binary and ternary blend-based LED devices with applied bias voltage. A control device was built comprising only large PbS QD as the active layer (i.e. single blend of QDs), and is plotted for comparison. All devices showed very high radiance of ~9 W sr$^{-1}$ m$^{-2}$ at 3.5 V, which is more than 50% higher compare to the previously reported PbS QD based IR LEDs [19, 21]. It is noteworthy that the turn-on voltage for both binary and ternary blend devices is around 0.6 V, i.e. below the bandgap of emission, while the turn-on voltage of the control device was 0.87 V, i.e. matching closely the bandgap of emission (note: we have considered 1 nW radiance as the turn on power). The electroluminescence spectra with different values of voltage bias for the ternary device are shown in Fig. 2b with clear band-edge electroluminescence emission at sub-band gap voltages. This is the lowest turn-on voltage ever reported for a PbS QD based LED. Although this below-bandgap turn-on value is not thermodynamically feasible in the absence of multi-carrier processes, it has been reported previously for polymer [34] and QD based LEDs [8], attributed to Auger assisted charge injection processes. According to this, the low-energy barrier for electron injection results in electron accumulation at the active layer and hole transporting layer (HTL) interface which can fulfil the condition for Auger assisted charge injection [8,34,35,36]. In the present invention, this is partially attributed to the improvement of mobility and trap passivation with the mixed ligand treatment employed herein as well as the use of bulk heterojunctions.

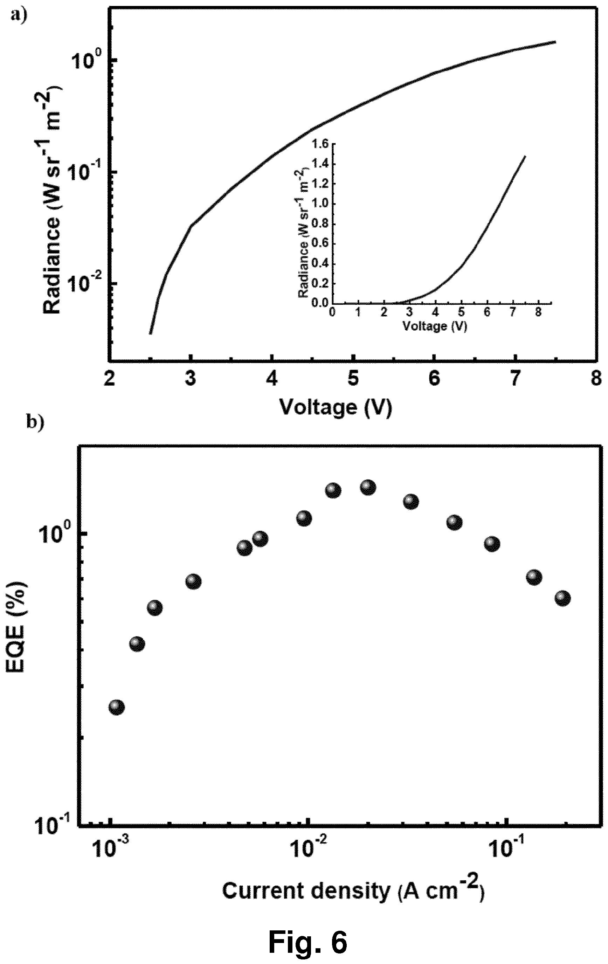

To examine the hypothesis about the role of the ligand passivation a ternary blend active layer device using only MPA as the ligand (MPA ligand exchange yields carrier mobility lower than the $ZnI_2$_MPA treatment) was fabricated. As shown in Figure 6, the device showed a much higher turn-on voltage (2.5 V) and lower radiance compared to the devices reported in this document. An additional plausible mechanism can be assigned to Auger assisted recombination in the small PbS QD matrix in which hole transport takes place via midgap delocalized states [37,38] and recombination with electrons transfers the energy to the remaining holes in those states enabling them to move to the valence band and subsequently inject into the emitting QDs.

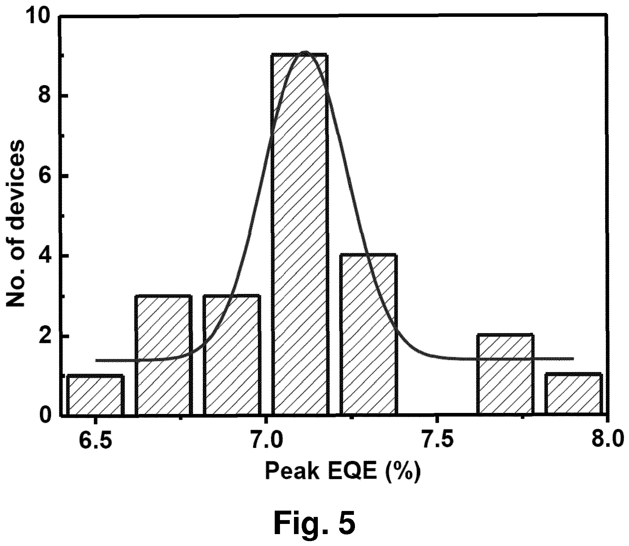

Despite the similar radiance measured across those three LED devices, a large difference in their driving currents was recorded, with the control (single) device yielding very high leakage current that progressively decreases in the binary and ternary blend cases (Fig. 2c). This has a significant effect in the EQE of the LEDs as shown in Fig. 2d. The peak EQE of the ternary device reached 7.87 % (average: (7.11 ± 0.30) %, Fig. 5) compared to 0.38 % ((0.3±0.07) %) for the single and 4.5% ((4.12±0.29) %) for binary QD based devices. The ternary blend based devices have reached record high EQE for CQD LEDs emitting at 1400 nm wavelength. Previously reported best devices showed the peak EQE around 5% covering a similar spectral range [10,21,23]. This is attributed to the trap passivation and the reduction of leakage current in the blend-devices. The high EQE recorded in the binary and ternary blend devices, taken together with the low turn-on voltage results also in unprecedentedly high PCE. Figure 2e plots the PCE of the LED devices from which the ternary blend based device outperforms with a peak PCE as high as 9.3%, a nearly twofold improvement over the previous record [21].

In course of device optimization and in order to demonstrate the versatility of the present invention, the present inventors have fabricated and measured several prototypes of the device of the present invention for which the active light emitting layer A comprises a ternary blend of QDs, with optimized blend ratio varying the bandgap of the PbS QD matrix as well as the bandgap of the PbS QD light emitters, the results of which are summarized in Table 1 below.

*Table 1: EQE values of LEDs varying the PbS QD matrix and the PbS QD emitter bandgaps*

| | | Average EQE (%) |
|---|---|---|
| PbS QD matrix bandgap 1.49 eV / PbS QD emitter bandgap: | 0.91 eV | 6.7±0.4 |
| | 0.89 eV | 7.11±0.30 |
| | 0.85 eV | 4.95±0.40 |
| PbS QD emitter bandgap 0.91 eV / PbS QD matrix bandgap: | 1.24 eV | 3.26±0.22 |
| | 1.31 eV | 4.94±0.32 |
| | 1.49 eV | 6.7±0.4 |

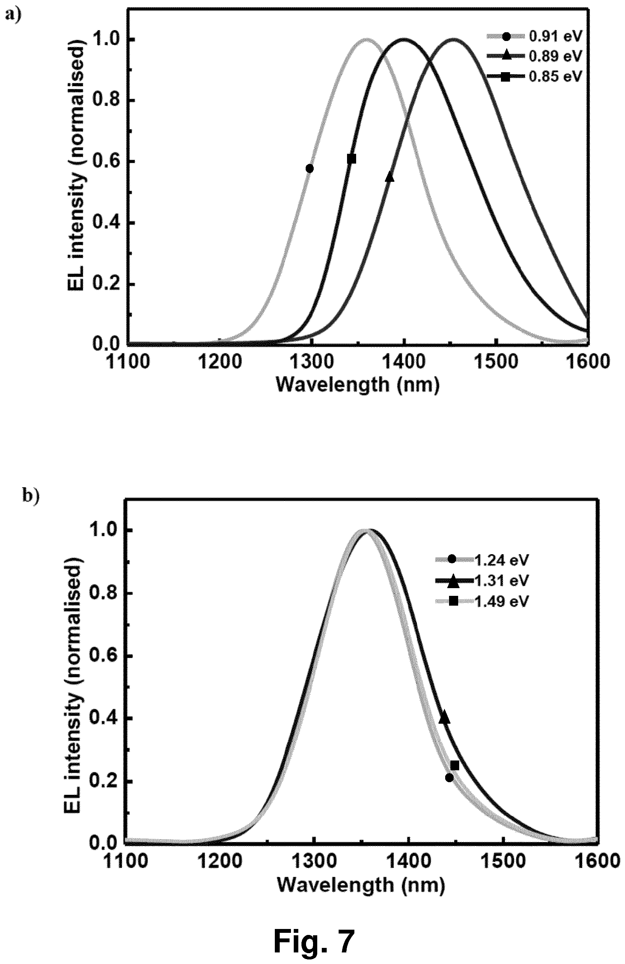

The electroluminescence spectra of various emitting PbS QD bandgaps are shown in Fig. 7a. The variation of the PbS QD matrix bandgap (Table 1 and Fig. 7b) revealed that optimized EQEs are achieved with increasing the bandgap of the PbS QD matrix, likely due to more efficient charge transfer to the emitting PbS QDs and increased confinement in the emitting QDs due to the larger band offset with the surrounding PbS QD matrix. Considering the fact that the device of the present invention are based entirely on CQD components with reported high stability [32,39], the stability of the best performing device has been tested under a constant applied current over a period of 48 hours. The radiance and the EQE of the device are highly stable throughout the course of the test as shown in Fig. 2f, especially considering that the devices were fabricated and characterised in ambient air conditions without any encapsulation.

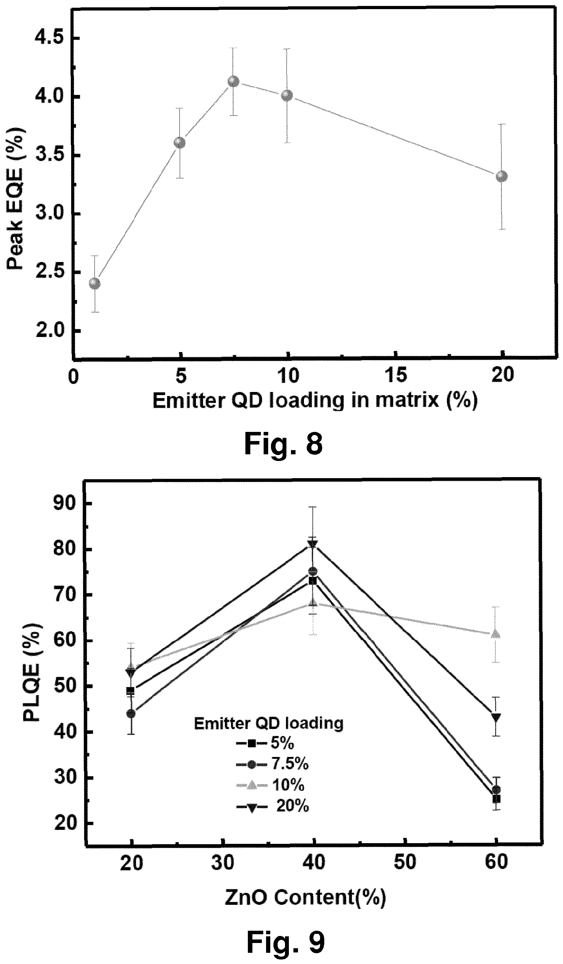

The origin of this high EQE lies on very high PLQE of the QD films employed and the present inventors therefore explored in more depth the role of the host matrix on the PLQE of the emitting QD species. Figure 3a plots the PL spectra for the ligand exchanged binary blend films varying the loading of emitting QDs in the small PbS QD matrix. The absence of PL emission from the matrix QDs upon blending corroborates highly efficient carrier transfer to the emitting QDs. This finding is in accordance to prior reports in which such high charge transfer has been ascribed to the increased coupling strength enabled in ligand exchanged electronically coupled QD solids [40]. Here, it has been made use of this effect to develop QD solids with considerably high PLQE under the following rationale: For a given density of poorly emitting (defective) large PbS QDs and a given QD film volume we envision a much higher PLQE when the large PbS QDs are introduced into a small PbS QD matrix, due to the proportionally lower number of defective large PbS QDs existent in the same volume. This hypothesis is valid when the matrix is absorbing at the optical excitation wavelength and possess long carrier diffusion lengths to supply the emitting QD species with electrons and holes. The schematic representation of this mechanism is illustrated in Fig. 3c,d. PLQE measurements of such binary blends are in agreement with the proposed mechanism. Fig. 3b plots the PLQE values of the binary blends varying the emitter QD loading in the host PbS QD matrix. An optimum PLQE of 60% is recorded for a loading of 10% of large PbS QDs in a small PbS QD host matrix, drastically increased over the 2.3% PLQE of the neat large PbS QD film. This is a remarkably high PLQE considering that refers to electronically conductive ligand exchanged QD solids. Increasing the amount of emitter QDs in the matrix reduces the PLQE as a result of increasing the probability of non-radiative recombination in the defective emitter QDs. Whereas decreasing the amount of emitter QDs in the matrix reduces the PLQE as a result of increasing the probability of non-radiative recombination in the host matrix considering a carrier diffusion length around 70 nm in the small PbS QD matrix [40]. Although the 10% emitter QD based binary blend yields the best PLQE, it does not yield the best EQE among different binary blends (Fig. 8). We attribute this to the trade-off between efficient balanced charge injection and PLQE.

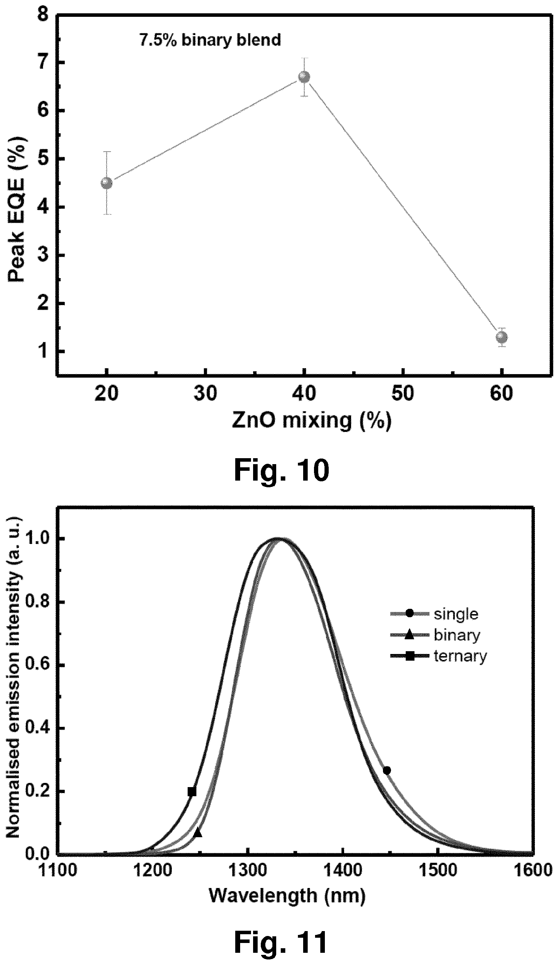

The synergistic use of ZnO NCs, in addition to improving balance of charge injection (as shown in Fig. 2c), offers the additional benefit of remotely passivating electron traps in the PbS QD emitters. The electrons of the n-type ZnO NCs, when in the vicinity of PbS QDs with electron traps available for population are used to electrically neutralize (passivate) those electron traps and result in higher radiative recombination efficiencies [28,29] (Fig. 3e). The PLQE of the ternary blend films as a function of PbS QD emitter loading in the PbS QD host matrix at a given ZnO loading of 40% is presented in Fig. 3b. According to this, a further increase in PLQE approaching a value of 80% for a loading of 20% of the emitting QD species is observed. The PLQE of the ternary blends with different PbS QD and ZnO ratios are shown in Fig. 9. In all types of PbS QD combinations, 40% ZnO loading in ternary blend gives the best PLQE and also the best EQE in LED devices, as shown in Fig. 10. It is noteworthy that the loading of emitter QDs in donor matrix or addition of ZnO NCs does not cause any spectral shift in the PL (Fig. 11), suggesting thus that the observed increase in the PLQE of the emitting PbS QDs is not due to suppression of energy transfer amongst them.

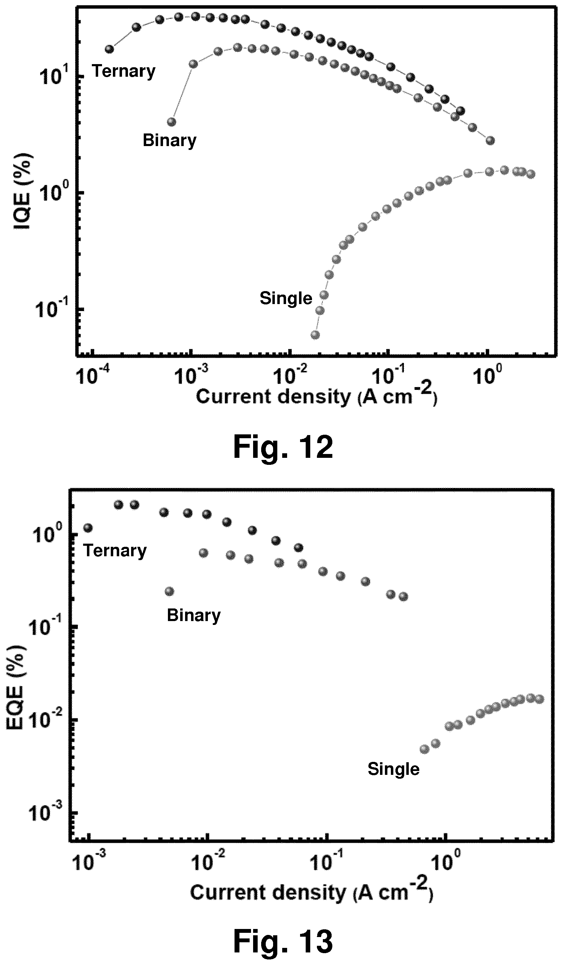

These very high PLQE values are also in line with the quantum efficiency values reported in the LED devices. In Fig. 12, the internal quantum efficiency (IQE) of the LED devices is plotted defined as the ratio of photon generated inside the device to the injected charge carriers. The ternary blend devices yield a peak IQE value of 33.3% whereas the binary blend shows IQE of 17.5%. The improvement in EQE and thereby IQE is nearly twofold, i.e. much higher than the improvement in the PLQE. This shows that the LED devices of the present invention built for the here described tests are current injection limited and further improvement in EQE can be within reach through device optimization. It also supports the hypothesis that the use of ZnO serves a twofold role: it improves the trap passivation and PLQE, as well as improves the balance of carrier injection since at the optimal LED configuration (40% ZnO loading).

A highly performing LED material, i.e. one having very high PLQE, is expected to be the ideal material for solar cell applications in demonstrating open circuit voltage ($V_{OC}$) very close to the radiative limit [41,42,43]. Having recorded such high PLQE values in electrically conductive QD solids in the present document, this expectation is also tested herein. The present inventors have therefore constructed, according to a further aspect of the present invention, photovoltaic (PV) cells based on the architectures considered previously for the LED devices of the present invention, essentially mimicking the LED structures with instead much thicker active layer A to facilitate high light absorption. The thickness of electron transporting, active and hole transporting layers were around 40 nm, 220 nm and 30 nm respectively and the PV structure followed a typical CQD solar cell [44]. The dark J-V characteristics, plotted as an inset of Fig. 4a, provide initial features of suppressed recombination upon blending, as evidenced by significantly lower reverse current of the blended-layer diodes compared to the single QD-layer diode case. The J-V curves of those cells under simulated AM1.5 solar illumination is shown in Fig. 4a. The $V_{OC}$ of the binary device increased to 0.59 V from 0.39 V of the single QD based device, which is a typical $V_{OC}$ value for PbS QD solar cells of the same bandgap [32]. The large $V_{OC}$ deficit (defined as the deficit of $V_{OC}$ from the bandgap voltage) for PbS QD based solar cells is believed to be a result of significant presence of non-radiative, in-gap traps [45]. The increased $V_{OC}$ (and subsequent decrease in $V_{OC}$ deficit) is a result of such trap passivation mechanism in accordance to the drastically improved PLQE values recorded for the binary blend films (Fig. 3b). The addition of ZnO further improves Voc to a value of 0.69 V for the ternary blend device. This is a notably large value of $V_{OC}$ that approaches the radiative limit [41] considering the fact that the solar cell harnesses photons with energies down to 0.92 eV. The radiative $V_{OC}$ limit of the PV devices was calculated following standard analysis [41,42], as described below with reference to Fig. 13.

*Radiative $V_{OC}$ limit calculation from the luminescent EQE of the solar cell:*

Radiative $V_{OC}$ can be calculated from the luminescent EQE of the PV devices [41,42]. The radiative $V_{OC}$ can be expressed as,

$$V_{OC,rad} = \frac{kT}{q}\ln\left(\frac{J_{SC}}{J_{em}}\right) \qquad (S1)$$

Where Jsc is the short circuit current density and $J_{em}$ is the emission current density. The luminescent EQE of the device can be given as,

$$EQE_{LED}(V) = \frac{J_{em}(V)}{J_{inj}(V)} \qquad (S2)$$

$J_{inj}$ is the injection current density of the device. From Shockley equation, the following expression can be written

$$J_{em}(V) \approx J_{em}\exp\left(\frac{qV}{kT}\right) \qquad (S3)$$

At $V_{int} = V_{OC}$, equation (S2) can be rewritten using equation (S3) as,

$$\ln\left(EQE_{LED}(V_{OC})\right) = \frac{qV_{OC}}{kT} + \ln\left(\frac{J_{em}}{J_{SC}}\right) \qquad (S4)$$

Putting the value of $V_{OC,rad}$ in equation (S4), the relation can be deduced as,

$$V_{OC,rad} - V_{OC} = -\frac{kT}{q}\ln(EQE_{LED}(V_{OC})) \qquad (S5)$$

The difference between the $V_{OC,rad}$ and $V_{OC}$ is caused by the non-radiative recombination loss in the device. Figure 13 showed the $EQE_{LED}$ of the PV devices to calculate the radiative $V_{OC}$ limit using equation (S5).

Figure 4b and Table 2 below summarise the radiative limit and non-radiative loss of the $V_{OC}$. Non-radiative losses decrease with binary blending compared to the single QDs and further decrease in ternary blend devices with ZnO loading. The EQE spectra of these solar cell devices (Fig. 4c) demonstrates their spectral coverage which is determined by the low-bandgap PbS QDs and its limited value in the infrared is ascribed to the low loading of the large PbS QDs.

Table 2: Radiative $V_{OC}$ derived from LED EQE of the PV devices.

| PV devices | $V_{OC}$ (V) | $EQE_{LED}$ (at $V_{int}=V_{OC}$) | $\Delta V_{OC, non-rad}$ (V) | $V_{OC, rad}$ (V) |
|---|---|---|---|---|
| Single | 0.39 | 0.005% | 0.26 | 0.65 |
| Binary | 0.59 | 0.54% | 0.13 | 0.72 |
| Ternary | 0.69 | 1.8% | 0.10 | 0.79 |

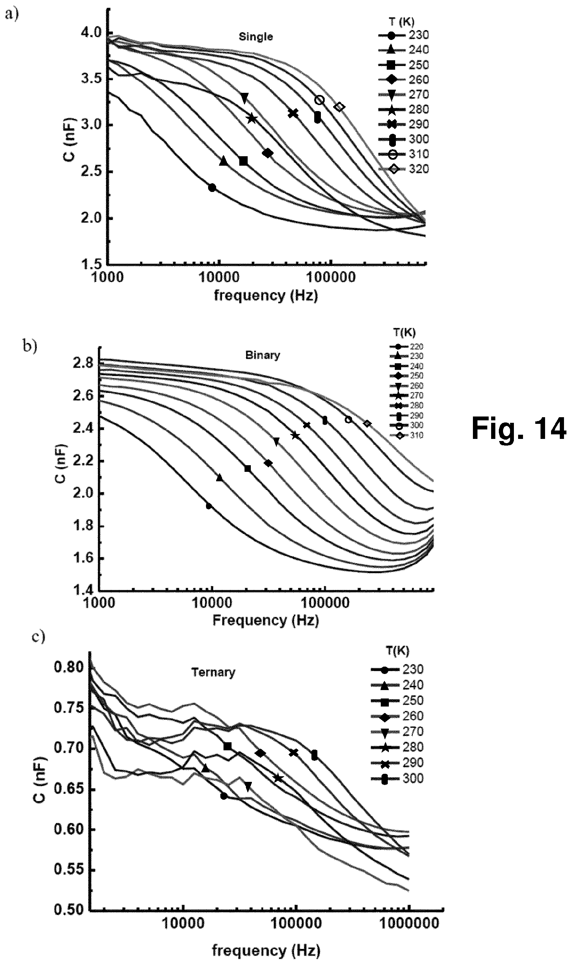

To further characterize and quantify the degree of trap-state passivation upon blending, thermal admittance spectroscopy (TAS) has been employed. TAS allows obtaining a quantitative picture of the in-gap trap distribution of the photoactive material as previously demonstrated on different types of PV devices [46,47]. The detailed analysis of the employed method is described below with reference to Fig. 14.

*Thermal Admittance Spectroscopy (TAS) analysis:*

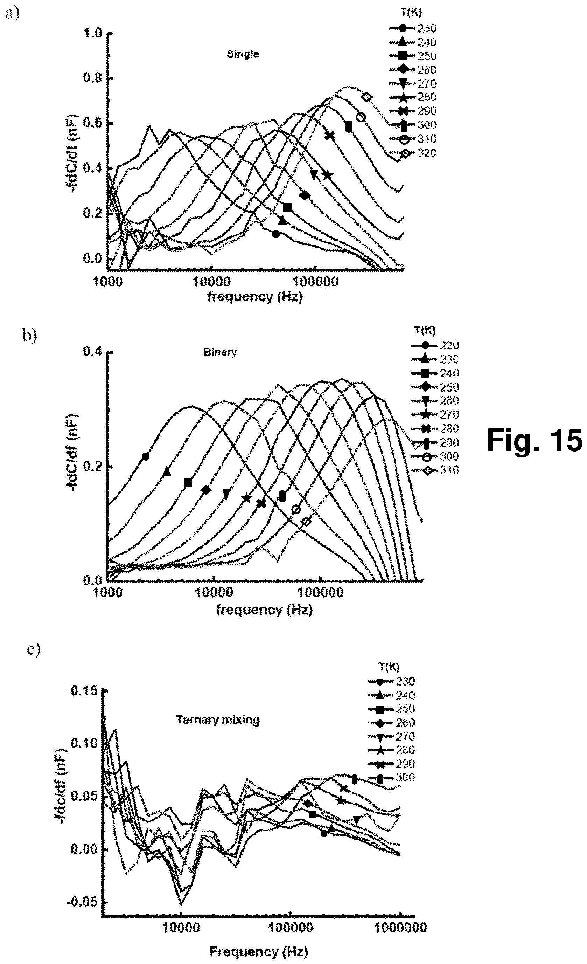

Several reports have been demonstrated over the years about the TAS procedure to analyse the in-gap traps in different types of PV [46,47,50]. The capacitance of the devices which is considered as the imaginary part of the admittance has been measured by the present inventors. The capacitance was scanned throughout the frequency region to find out the turn-over frequency (resonance frequency) for a particular temperature (Figs. 14 and 15). Now, the turn-over frequency ($f_0$) at a particular temperature ($T$) can be correlated to the trap escape frequency ($\xi_0$) as,

$$f_0 = 2\xi_0 T^2 \exp(\frac{-E_A}{k_b T}) \qquad\qquad (S6)$$

Where $E_A$ is the trap activation energy and $k_b$ is the Boltzman's constant. Equation (S6) can estimates the value of $E_A$ (Arrhenius plot). The trap distribution ($N_t$) for a linear band heterojunction device can be written as [41],

$$N_t\left(E_f\right) = \frac{-V_{bi}^2}{W_D[qV_{bi}-(E_{fn\infty}-E_f)]}\frac{dC}{df}\frac{f}{k_b T} \qquad\qquad (S7)$$

Where $V_{bi}$ and $W_D$ are the built-in potential and depletion width of the device which were calculated from standard Mott-Schottky analysis. $E_{fn\infty}$ is the bulk fermi level (far from the junction) of the active material. $E_f$ can be written by modifying the equation (S6) as,

$$E_f = k_b T \, ln(\frac{2\xi_0 T^2}{f}) \qquad\qquad (S8)$$

The C-f and (-fdC/df)-f plots are shown in Figs. 14 and 15 respectively. The $N_t$ was plotted as a function of $E_f$ using equations S2 and S3. The total trap was estimated by the integration of $N_t$ throughout the energy spectra.

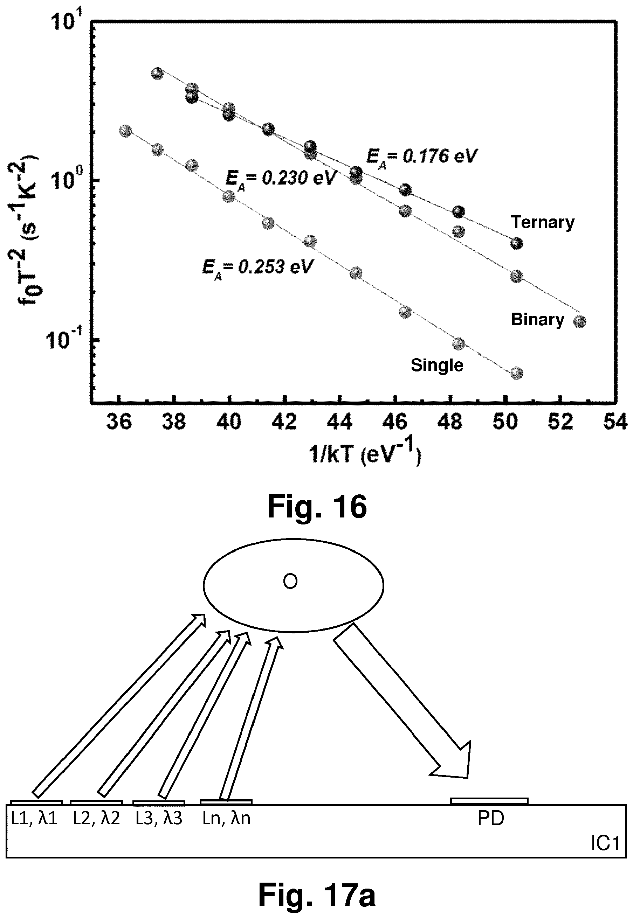

The trap distribution as a function of $E_t$ (position of trap state with respect to the band-edge) deduced from TAS analysis gives a clearer picture of trap reduction upon QD blending as shown in Fig. 4d. $E_t$ decreases from 0.254 eV for single QD based device to 0.237 eV for binary blending and further reduces to 0.174 eV for ternary blend. The position of $E_t$ follows similar trend like trap activation energy ($E_A$) as determined from Arrhenius plot (Fig. 16). The overall trap-state density decreased from $10^{16}$cm$^{-3}$ for single QDs based device to $4.85\times10^{15}$ cm$^{-3}$ for binary QDs and further down to $6.5\times10^{14}$ cm$^{-3}$ for ternary QDs based device. These results from TAS also corroborate the here presented hypothesis on the passivation mechanism at play upon binary and ternary blending. In the case of binary blending there is a reduction of trap states without much alteration of the energetic value of the traps, in accordance to the model described in Fig. 3d. Upon ternary blending, in addition to the reduction of the trap density, there is also a significant lowering of the trap-state depth due to the remote passivation facilitated by the ZnO NCs (Fig. 3e). Theoretically, Gong *et al.* have shown the influence of trap-state reduction on the enhancement of radiative recombination [21]. Here the present inventors have achieved experimentally for the first time such low trap-state density in CQD films and have presented record performing light emitting CQD thin films with important implications in the development of highly efficient LEDs and solar cells approaching the theoretical limits in open circuit voltage.

## Methods

*Synthesis of PbS QDs:*

Schlenk technique was used to synthesize PbS QDs. 830 nm and 940 nm excitonic peak based PbS QDs were synthesized following the standard recipe. 2 mmol lead oxide (PbO), 4.7 mmol oleic acid, and 9.4 mmol 1-octadecene (ODE) were pumped overnight at 95 °C. Then 15 mL of ODE was added and the temperature of the reaction was adjusted to 75°C or 100 °C for 830 nm and 940 nm PbS QDs, respectively. When the temperature point is reached, 1 mmol hexamethyldisilane (TMS) mixed with 10 mL ODE was immediately injected. The heating was stopped (without removing the heating mantle) and the sample allowed to cool down gradually (~1 h). The NCs were isolated by adding acetone and then centrifuged, purified by dispersion/precipitation with toluene/acetone 3 times, and finally dispersed in anhydrous toluene (30 mg mL$^{-1}$) before using them for device formation.

1300 nm excitonic peak based PbS QDs were synthesized by a previously reported multi-injection method with modifications [48]. Typically, PbO (0.45 g), oleic acid (3.8 mL) and ODE (50 mL) were mixed together at 95 °C under vacuum for 12 h. Then the temperature of the reaction was raised to 100 °C. The solution of 90 $\mu$L TMS in 3ml ODE was injected, the additional 3 injections (25 $\mu$L TMS in 3 mL ODE for each injection) were sequentially followed by a fixed time. When the injection was finished, the heating was stopped immediately and the sample was allowed to cool down gradually to room temperature under constant stirring. QDs were precipitated by adding acetone, followed by centrifugation, purified in air by using toluene/acetone as solvent/anti-solvent. The final QDs were dispersed in toluene with a concentration of 30 mg mL$^{-1}$ for device fabrication.

*ZnO nanocrystals preparation:*

ZnO nanocrystals were prepared following a previously reported method[28]. 2.95 g zinc acetate dihydrate was dissolved in 125 mL methanol under vigorous stirring and the temperature of the solution was set at 60 °C. At the same time, in a separate vial 1.48 g KOH (90%) was dissolved in 65 mL methanol solution. The prepared KOH solution was then added dropwise to the zinc acetate solution for a period of 4 minutes while the temperature was kept at 60°C with constant stirring. The reaction conditions were left unaltered for the next 2.5 hours. After completion of the reaction, the heating source was removed and the solution was allowed to cool down slowly to room temperature. The solution was then centrifuged at 3500 rpm for 5 min. The supernatant was discarded and an equal amount of methanol was added and centrifugation repeated. After three rounds of purification, the NCs were dispersed in a solution of 2% butylamine in chloroform for base layer formation and in 5% butylamine in toluene for ternary blend formation.

*LED device preparation:*

LEDs were prepared on cleaned ITO coated glass. The electron transporting layer (ZnO) was prepared by spin coating ZnO nanocrystals in chloroform (40 mg mL$^{-1}$) with a spin speed of 4000 rpm. The procedure was repeated once more to have a thicker film of approximately 80 nm. The active emitting layer was grown on top of the ZnO layer. Before mixing, all QDs and ZnO NC solutions were prepared in separate vials with the same concentration (30 mg ml$^{-1}$). For binary blends, emitter PbS QDs were mixed to donor PbS QDs with different volume ratios. Ternary blends were formed by mixing ZnO NC solution to the binary blend with different volume ratios. During the film formation, QDs were treated with $ZnI_2$ and MPA mixed ligand as described in a previous report [33] of the present inventors. The mix ligand was prepared by mixing 25 mM $ZnI_2$ in methanol and 0.015% MPA in methanol solutions. The ZnO substrates were covered with 50 μL of QD solutions and spun immediately with 2500 rpm for 15 sec. Then, the spin coater was stopped to add few drops of mixed ligand to treat for 5 sec. After that, the spincoater was started to dry the film which was then washed with few drops of methanol. The procedure was repeated thrice to get an average thickness of 60 nm. The hole transporting layer was formed by using small diameter PbS QDs treated with 0.02% EDT in acetonitrile solution. The back electrode was formed with Au deposition through a pre-patterned shadow mask in thermal evaporator (Nano 36 Kurt J. Lesker) at a base pressure of 10$^{-6}$ mbar. The active area for each device is 3.14 mm$^2$.

*LED performance characterization:*

All the devices were fabricated and characterized in ambient air conditions. Current density-voltage (J-V) characteristics were recorded using a computer-controlled Keithley 2400 source measurement unit. To calculate the EQEs, electroluminescence from the front face of the device was detected using a calibrated Newport 918D-IR-OD3 germanium photodetector connected to Newport 1918-C power meter in parallel to the J-V measurements. A Shadow mask of 3 mm in diameter was placed in front of the device to minimize the waveguide effect from ITO coated glass. Lambertian emission was assumed. The thickness of the glass substrate was considered during the solid angle measurement. The radiance was further verified with a NIST certified 818-IG InGaAs photodetector with calibrated DB15 module by Newport.

*PL and PLQE measurements:*

PL measurements were performed using a Horiba Jobin Yvon iHR550 Fluorolog system coupled with a Hamamatsu RS5509-73 liquid-nitrogen cooled photomultiplier tube, and a calibrated Spectralon™ coated Quanta-phi integrating sphere. All reported steady-state PL spectra and photoluminescence quantum efficiency (PLQE) measurements were collected using a continuous-wave Vortran Stradus 637 laser diode as excitation source (λ = 637 nm, maximum power = 80 mW), and all reported steady-state PL spectra have been corrected for the system response function. Both binary and ternary blend films used in the PL measurements were prepared via aforementioned layer-by-layer deposition using the mixed-ligand-exchange procedure (5 layers) onto (3-mercaptopropyl) trimethoxysilane (MPTS) functionalized glass. Such treatment was used to improve the adhesion of the QDs on glass to obtain continuous and uniform QD films. The treatment was performed prior QDs deposition by inserting 1×1cm glass substrates into a petri dish containing a MPTS toluene solution (10% by volume) then removed after 24h and gently dried under a flux of nitrogen.

The PLQE measurements were carried out as following: initially, the PLQE of a 100 nm thick film of PbS QDs (reference film) was measured inside the calibrated integrating sphere using the procedure proposed by De Mello et al. [49] ($\lambda_{PL}$ =1100 nm, film was fabricated following the method described above) yielding a PLQE of 24 ± 3%. The emission intensity of the film was then measured in the sample chamber of the fluorimeter (i.e. outside the integrating sphere) using predetermined and fixed excitation and collection conditions. By comparing the emission intensity measured outside and inside the integrating sphere, and the optical absorption at the excitation wavelength obtained inside the integrating sphere, we obtained a correction factor (i.e. the PLQE of the reference film calculated using the number of emitted photons measured in the fluorimeter sample chamber and the number of absorbed photons measured in the integrating sphere was 48 times higher than the real value). Afterward, all other films were measured using the same procedure (number of absorbed photons measured inside the sphere, number of emitted photons measured in the fluorimeter sample chamber) using the predetermined and fixed excitation and collection conditions employed for the reference film, and the correction factor was applied to obtain the PLQE value.

The above method was employed for all the PLQE values reported in the manuscript as it was not possible to use the Quanta-phi integrating sphere for $\lambda_{PL}$ > 1200 nm as the fibre bundles interfacing the Quanta-phi integrating sphere to the Horiba Jobin Yvon iHR550 Fluorolog system are not transparent in this spectral range. The obtained correction factor from the reference film accounts for the response function of the whole fluorimeter and detector. Yet, considering the different emission wavelength of the reference film ($\lambda_{PL}$ =1100 nm) and the blended films ($\lambda_{PL}$ =1371 nm), a deviation of the correction factor value can arise from the different spectral reflectivity of the sphere although Spectralon™ presents small reflectance variation in this spectral region (less than 1%).

*EL measurements:*

Spectral EL measurements were also performed using a Horiba Jobin Yvon iHR550 Fluorolog system coupled with a Hamamatsu RS5509-73 liquid-nitrogen cooled photomultiplier tube. The voltage bias to the device was applied with a Keithley 2400 source measurement unit. The acquired spectra were corrected using the system response factor provided by the manufacturer.

*Photovoltaic device preparation and characterizations:*

The PV device preparation follows a similar procedure as the LED described above other than the thickness of the respective layers. The ZnO base layer was deposited thinner compared to LED device (~40 nm). The active layer was prepared much thicker in order to absorb sufficient photons (-200-220 nm). Finally, 2 layers of EDT treated PbS (-30-35 nm) were used as electron blocking layer. Approximately 100 nm Au was deposited as the back electrode. The active area of the device was 3.14 mm$^2$. All the PV characterizations were performed in ambient conditions. The device I-V responses were collected using a Keithley 2400 source meter. Illumination intensity of AM 1.5 was maintained using a class AAA solar simulator (Oriel sol3A, Newport Corporation). The accuracy of the measurement was determined as $\pm$4%. EQE measurements were performed with an in-house built experimental set-up by using chopped (220 Hz, Thorlab) monochromatic illumination. The power was measured with a calibrated Newport-UV power meter. The device response of the chopped signal was measured using a Stanford Research system lock-in amplifier (SR830) which was fed by a Stanford Research system low noise current pre-amplifier (SR570). The final EQE spectra were obtained with the help of LabVIEW program.

*Thermal admittance spectroscopy (TAS) measurements:*

The measurements were performed with the PV devices in a Lakeshore four probe cryogenic chamber controlled by a Lakeshore-360 temperature controller. The frequency dependent capacitance was measured with an Agilent B1500 connected with an external capacitance measurement unit. The temperature was varied from 220 K to 320 K to acquire the frequency dependent capacitance variation. The voltage dependent capacitance was measured with the same instrument in order to obtain the value of depletion width and built-in voltage. The detailed data analysis procedure has been described above with reference to Fig. 14.

*TEM measurements:*

The bright field (BF) TEM images of the films have been obtained with JEOL JEM-2100 (LaB$_6$ electron gun) transmission electron microscope, operating at 200 kV. The samples were prepared by spin coating the QD solutions onto 300-mesh carbon-coated copper grid at 2500 rpm. Then, the ligand exchange with ZnI$_2$_MPA was performed in line with the aforementioned device fabrication procedure.

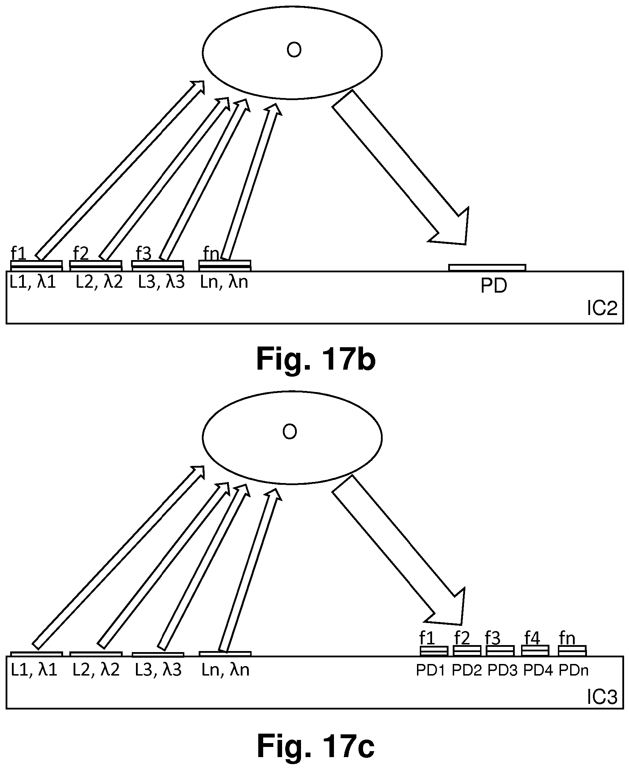

Finally, three respective embodiments for the spectrometer of the present invention and associated operations are shown in Figures 17a, 17b and 17c.

Specifically, for the embodiment of Figure 17a the spectrometer comprises multiple LEDs, L1, L2, L3 ... Ln, each emitting light with a different wavelength, λ1, λ2, λ3 ... λn, towards an object O under test, and a photodetector PD configured and arranged to receive the light emitted by the LEDs once reflected (or transmitted) by the object O. For this embodiment, LEDs L1, L2, L3 ... Ln are excited sequentially and so is the photo-detection and readout performed by the photodetector PD for each wavelength λ1, λ2, λ3 ... λn. In this case, the LEDs L1, L2, L3 ... Ln and photodetector PD are embedded in a CMOS read-out chip IC1.

The embodiment of Figure 17b is an improvement to that of Figure 17a and differs therefrom ion that the spectrometer further comprises corresponding bandpass filters, f1, f2, f3 ... fn, in front of the LEDs L1, L2, L3 ... Ln, for spectral enhancement. A CMOS read-out chip IC2 embedding the LEDs L1, L2, L3 ... Ln and photodetector PD is provided.

A different embodiment is shown in Figure 17c, where a simultaneous excitation of all the LEDs, L1, L2, L3 ... Ln, comprised by the spectrometer (having different wavelengths $\lambda 1$, $\lambda 2$, $\lambda 3$ ... $\lambda n$) is performed, and also a simultaneous photo-detection and readout is carried out by means of a photodetector array including multiple photodetectors, PD1 to PDn, with respective bandpass filters f1, f2, f3, f4 ... fn, each with a different bandpass range (e.g. f1: 1300 - 1350 nm, f2: 1350-1400 nm, f3: 1400 - 1450 nm, etc.), so that each photodetector detects light within the wavelength range of the associated bandpass filter. In this case, a chip IC3 embeds the LEDs, the photodetector array and also electric bias, synchronization and read-out electronics.

The invention is defined by the appended claims.

**References:**

(1) Konstantatos, G. etal. Ultrasensitive solution-cast quantum dot photodetectors. Nature 442, 180-183 (2006).

(2) Sargent, E. H. Colloidal quantum dot solar cells. Nat. Photonics 6, 133-135 (2012).

(3) Liu, M. et al. Hybrid organic-inorganic inks flatten the energy landscape in colloidal quantum dot solids. Nat. Mater. 16, 258-263 (2017).

(4) Anikeeva, P. O., Halpert, J. E., Bawendi, M. G. & Bulovic', V. Quantum dot light-emitting devices with electroluminescence tunable over the entire visible spectrum. Nano Lett. 9, 2532-2536 (2009).

(5) Shirasaki, Y., Supran, G. J., Bawendi, M. G. & Bulovic, V. Emergence of colloidal quantum-dot light-emitting technologies. *Nat. Photonics* **7**, 13-23 (2013).

(6) Pal, B. N. et al. 'Giant' CdSe/CdS core/shell nanocrystal quantum dots as efficient electroluminescent materials: strong influence of shell thickness on light-emitting diode performance. Nano Lett. 12, 331-336 (2012).

(7) Hines, M. A. & Scholes, G. D. Colloidal PbS nanocrystals with size-tunable near-infrared emission: observation of post-synthesis self-narrowing of the particle size distribution. Adv. Mater. 15, 1844-1849 (2003).

(8) Mashford, B. S. etal. High-efficiency quantum-dot light-emitting devices with enhanced charge injection. Nat. Photonics 7, 407-412 (2013).

(9) Dai, X. et al. Solution-processed, high-performance light-emitting diodes based on quantum dots. Nature 515, 96-99 (2014).

(10) Supran, G. J. etal. High-performance shortwave-infrared light-emitting devices using core-shell (PbS-CdS) colloidal quantum dots. Adv. Mater. 27, 1437-1442 (2015).

(11) Borek, C. et al. Highly efficient, near-infrared electro phosphorescence from a Pt-metalloporphyrin complex. Angew. Chem. 46, 1109-1112 (2007).

(12) Goossens, S. et al. Broadband image sensor array based on graphene-CMOS integration. Nat. Photonics 11, 366-371 (2017).

(13) Murphy, C. J. Optical sensing with quantum dots. Anal. Chem. 74, 520A-526A (2002).

(14) Medintz, I. L., Uyeda, H. T., Goldman, E. R. & Mattoussi, H. Quantum dot bio conjugates for imaging, labelling and sensing. Nat. Mater. 4, 435-446 (2005).

(15) Voura, E. B., Jaiswal, J. K., Mattoussi, H. & Simon, S. M. Tracking early metastatic progression with quantum dots and emission scanning microscopy. Nat. Med. 10, 993-998 (2004).

(16) Park, S. I. et al. Soft, stretchable, fully implantable miniaturized optoelectronic systems for wireless optogenetics. Nat. Biotechnol. 33, 1280-1286 (2015).

(17) Kim, J. et al. Battery-free, stretchable optoelectronic systems for wireless optical characterization of the skin. Sci. Adv. 2, e1600418 (2016).

(18) Lopez, A., Arazuri, S., Garcia, I., Mangado, J. & Jaren, C. A review of the application of near-infrared spectroscopy for the analysis of potatoes. J. Agric. Food Chem. 61, 5413-5424 (2013).

(19) Sun, L. et al. Bright infrared quantum-dot light-emitting diodes through inter-dot spacing control. Nat. Nanotechnol. 7, 369-373 (2012).

(20) Yang, Z. et al. All-quantum-dot infrared light-emitting diodes. ACS Nano 9, 12327-12333 (2015).

(21) Gong, X. et al. Highly efficient quantum dot near-infrared light-emitting diodes. Nat. Photonics 10, 253-257 (2016).

(22) Bourdakos, K. N., Dissanayake, D. M. N. M., Lutz, T., Silva, S. R. P. & Curry, R. J. Highly efficient near-infrared hybrid organic-inorganic nanocrystal electroluminescence device. Appl. Phys. Lett. 92, 153311 (2008).

(23) Yang, X. et al. Iodide capped PbS/CdS core-shell quantum dots for efcient long wavelength near-infrared lightemitting diodes. Sci. Reports 7, 14741 (2017).

(24) Colvin, V. L., Schlamp, M. C. & Alivisatos, A. P. Light-emitting diodes made from cadmium selenide nanocrystals and a semiconducting polymer. Nature 370, 354-357 (1994).

(25) Tessler, N., Medvedev, V., Kazes, M., Kan, S. & Banin, U. Efficient near-infrared polymer nanocrystal light-emitting diodes. Science 295, 1506-1508 (2002).

(26) Konstantatos, G., Huang, C., Levina, L., Lu, Z. & Sargent, E. H. Efficient infrared electroluminescent devices using solution-processed colloidal quantum dots. Adv. Func. Mater. 15, 1865-1869 (2005).

(27) Roy Choudhury, K., Song, D. W. & So, F. Efficient solution-processed hybrid polymer-nanocrystal near infrared light-emitting devices. Org. Electron. 11, 23-28 (2010).

(28) Rath, A. K. et al. Remote trap passivation in colloidal quantum dot bulk nano-heterojunctions and its effect in solution-processed solar cells. Adv. Mater. 26, 4741-4747 (2014).

(29) Pradhan, S., Stavrinadis, A., Gupta, S., Christodoulou, S. & Konstantatos, G. Breaking the open-circuit voltage deficit floor in pbs quantum dot solar cells through synergistic ligand and architecture engineering. ACS Energy Lett. 2, 1444-1449 (2017).

(30) Carey, G. H., Levina, L. Comin, R., Voznyy, O. & Sargent, E. H. Record charge carrier diffusion length in colloidal quantum dot solids via mutual dot-to-dot surface passivation. Adv. Mater. 27, 3325-3330 (2015).

(31) Zhitomirsky, D. etal. Engineering colloidal quantum dot solids within and beyond the mobility-invariant regime. Nat. Commun. 5, 3803 (2014).

(32) Bi, Y. et al. Infrared solution-processed quantum dot solar cells reaching external quantum efficiency of 80% at 1.35 $\mu$m and JSC in excess of 34 mA cm-2. Adv. Mater. 30, 1704928 (2018).

(33) Pradhan, S. et al. Trap-state suppression and improved charge transport in pbs quantum dot solar cells with synergistic mixed-ligand treatments. Small 13, 1700598 (2017).

(34) Qian, L. et al. Electroluminescence from light-emitting polymer/ZnO nanoparticle heterojunctions at sub-bandgap voltages. Nano Today 5, 384-389 (2010).

(35) Ji, W. et al. The work mechanism and sub-bandgap-voltage electroluminescence in inverted quantum dot light-emitting diodes. Sci. Reports 4, 6974 (2014).

(36) Li, J. et al. Single-layer halide perovskite light-emitting diodes with sub-band gap turn-on voltage and high brightness. J. Phys. Chem. Lett. 7, 4059-4066 (2016).

(37) Nagpal, P. & Klimov, V. I. Role of mid-gap states in charge transport and photoconductivity in semiconductor nanocrystal films. Nat. Commun. 2, 486 (2011).

(38) Bae, W. K. etal. Controlling the influence of Auger recombination on the performance of quantum-dot light-emitting diodes. Nat. Commun. 4, 2661 (2013).

(39) Cao, Y., Stavrinadis, A., Lasanta, T., So, D. & Konstantatos, G. The role of surface passivation for efficient and photostable PbS quantum dot solar cells. Nat. Energy 1, 16035 (2016).

(40) Zhitomirsky, D.,Voznyy, O., Hoogland, S. & Sargent, E. H. Measuring charge carrier diffusion in coupled colloidal quantum dot solids. ACS Nano 7, 5282-5290 (2013).

(41) Rau, U. Reciprocity relation between photovoltaic quantum efficiency and electroluminescent emission of solar cells. Phys. Rev. B 76, 085303 (2007).

(42) Yao, J. et al. Quantifying losses in open-circuit voltage in solution-processable solar cells. Phys. Rev. Applied 4, 014020 (2015).

(43) Tress, W. Perovskite solar cells on the way to their radiative efficiency limit - insights into a success story of high open-circuit voltage and low recombination. Adv. Energy Mater. 7, 1602358 (2017).

(44) Chuang, C. -H. M., Brown, P. R., Bulovic, V. & Bawendi, M. G. Improved performance and stability in quantum dot solar cells through band alignment engineering. *Nat. Mater.* 13, 796-801 (2014).

(45) Chuang, C. -H. M. et al. Open-circuit voltage deficit, radiative sub-bandgap states, and prospects in quantum dot solar cells. Nano Lett. 15, 3286- 3294 (2015).

(46) Walter, T., Herberholz, R., Müller, G. & Schock, H. W. Determination of defect distributions from admittance measurements and application to Cu(In,Ga)Se2 based heterojunctions. J. Appl. Phys. 80, 4411 (1996).

(47) Bozyigit, D., Volk, S., Yarema, O. & Wood, V. Quantification of deep traps in nanocrystal solids, their electronic properties, and their influence on device behavior. Nano Lett. 13, 5284-5288 (2013).

(48) Lee, J. W., Kim, D. Y., Baek, S., Yu, H. & So, F. Inorganic UV-Visible-SWIR broadband photodetector based on monodisperse PbS nanocrystals. Small 12, 1328-1333 (2016).

(49) de Mello, J. C., Wittmann, H. F. & Friend, R. H. An improved experimental determination of external photoluminescence quantum efficiency. Adv. Mater. 9, 230-232 (1997).

(50) Jin, Z., Wang, A., Zhou, Q., Wang, Y. & Wang, J. Detecting trap states in planar PbS colloidal quantum dot solar cells. Sci. Reports, 6, 37106 (2016).

**Claims**

1. A light emitting device comprising:

    - a substrate;
    - a first electrode (E1) formed by a first electrically conductive layer arranged over said substrate;
    - an active light emitting layer (A) arranged over said first electrically conductive layer, and that comprises a host matrix and light emitting quantum dots embedded there within; and
    - a second electrode (E2) formed by a second electrically conductive layer arranged over said active light emitting layer (A);

    wherein said host matrix comprises charge carrier supplier quantum dots blended with said light emitting quantum dots, forming a binary blend where the charge carrier supplier quantum dots are made and arranged to supply charge carriers to the light emitting quantum dots, wherein the light emitting quantum dots are made and arranged to accept the supplied charge carriers, and **characterized in that** the light emitting quantum dots are homogeneously dispersed within the host matrix and distanced above 3 nm from each other.

2. The light emitting device of claim 1, wherein said host matrix comprises a ternary blend formed by said binary blend and further quantum dots made and arranged to passivate electronically possible electron traps of the light emitting quantum dots and to balance charge carrier injection.

3. The light emitting device of claim 1 or 2, wherein said charge carrier supplier quantum dots are smaller than said light emitting quantum dots, have a larger bandgap and form a type-I heterojunction therewith.

4. The light emitting device of claim 3 when depending on claim 2, wherein said further quantum dots have a bandgap that is larger than that of the charge carrier supplier quantum dots, and a band alignment with respect to the bands of the charge carrier supplier quantum dots and light emitting quantum dots that favours injection of electrons or holes in the light emitting quantum dots, but not both.

5. The light emitting device of any of claims 1 to 4, wherein the concentration of the light emitting quantum dots in the binary or ternary blend ranges from 1% up to 20% by volume, and the concentration of the charge carrier supplier quantum dots in the binary or ternary blend ranges from 80% up to 99% in volume, preferably from 50% up to 99% by volume.

6. The light emitting device of claim 5 when depending on claim 2, wherein the concentration of the further quantum dots in the ternary blend ranges between 20% and 50% by volume, preferably from 30% up to 50%.

7. The light emitting device of any of the previous claims, wherein the host matrix forms an electrically conductive percolating path, while the light emitting quantum dots are dispersed within the host matrix so distanced and isolated from each other that they do not form any electrically conductive path.

8. The light emitting device of any of the previous claims, wherein the charge carrier supplier quantum dots possess carrier diffusion lengths larger than 10 nm for both types of charge carriers, electrons and holes, preferably in a range from 10 nm up to 500 nm.

9. The light emitting device of any of the previous claims, further comprising:

- an electron injecting and hole blocking layer (Ie) arranged between said active light emitting layer (A) and one of said first (E1) and second (E2) electrodes; and
- a hole injecting and electron blocking layer (Ih) arranged between said active light emitting layer (A) and the other of said first (E1) and second (E2) electrodes.

10. The light emitting device of claim 9, wherein said electron injecting and hole blocking layer (Ie) is arranged between the active light emitting layer (A) and the first electrode (E1), and wherein the hole injecting and electron blocking layer (Ih) is a semiconductor layer that forms a type-II heterojunction with all of the quantum dots of the active light emitting layer (A).

11. The light emitting device of claim 10, wherein the hole injecting and electron blocking semiconductor layer (Ih) comprises quantum dots.

12. The light emitting device of any of the previous claims, wherein both the charge carrier supplier quantum dots and the light emitting quantum dots are PbS quantum dots, and/or wherein the further quantum dots are ZnO nanocrystals.

13. The light emitting device of any of the previous claims, wherein the light emitting device is made to emit infrared, near infrared and/or short-wave infrared light.

14. An optical spectrometer, comprising the light emitting device according to any of the previous claims, for emitting light with different wavelengths onto an object, and at least one photodetector made to detect light with any of said different wavelengths.

16

**15.** A down-converting film for a light emitting device, where the down-converting film is configured and arranged to be placed atop said light emitting device to absorb and down convert light emitted thereby, and wherein it comprises an active light emitting layer (A) that comprises a host matrix and light emitting quantum dots embedded there within, **characterised in that** said host matrix comprises charge carrier supplier quantum dots blended with said light emitting quantum dots, forming a binary blend where the charge carrier supplier quantum dots are made and arranged to supply charge carriers to the light emitting quantum dots, wherein the light emitting quantum dots are made and arranged to accept the supplied charge carriers, and wherein the light emitting quantum dots are homogeneously dispersed within the host matrix and distanced above 3 nm from each other.

**Patentansprüche**

**1.** Lichtemittierende Vorrichtung, umfassend:

- ein Substrat;
- eine erste Elektrode (E1), die durch eine erste elektrisch leitende Schicht, die über dem Substrat angeordnet ist, gebildet ist;
- eine aktive lichtemittierende Schicht (A), die über der ersten elektrisch leitenden Schicht angeordnet ist und die eine Wirtsmatrix und darin eingebettete lichtemittierende Quantenpunkte enthält, und
- eine zweite Elektrode (E2), die durch eine zweite elektrisch leitende Schicht, die über der aktiven lichtemittierenden Schicht (A) angeordnet ist, gebildet ist;

wobei die Wirtsmatrix ladungsträgerliefernde Quantenpunkte enthält, die mit den lichtemittierenden Quantenpunkten gemischt sind, eine binäre Mischung bilden, wobei die ladungsträgerliefernden Quantenpunkte dafür ausgebildet und angeordnet sind, den lichtemittierenden Quantenpunkten Ladungsträger zuzuführen, wobei die lichtemittierenden Quantenpunkte dafür ausgebildet und angeordnet sind, die zugeführten Ladungsträger anzunehmen, **dadurch gekennzeichnet, dass** die lichtemittierenden Quantenpunkte innerhalb der Wirtsmatrix homogen dispergiert sind und um mehr als 3 nm voneinander beabstandet sind.

**2.** Lichtemittierende Vorrichtung nach Anspruch 1, wobei die Wirtsmatrix eine ternäre Mischung enthält, die durch die binäre Mischung und weitere Quantenpunkte, die dafür ausgebildet und angeordnet sind, elektronisch mögliche Elektronenfallen der lichtemittierenden Quantenpunkte passiv zu machen und die Ladungsträgerinjektion auszugleichen, gebildet ist.

**3.** Lichtemittierende Vorrichtung nach Anspruch 1 oder 2, wobei die ladungsträgerliefernden Quantenpunkte kleiner als die lichtemittierenden Quantenpunkte sind, einen größeren Bandabstand aufweisen und damit einen Typ-I-Heteroübergang bilden.

**4.** Lichtemittierende Vorrichtung nach Anspruch 3, wenn abhängig von Anspruch 2, wobei die weiteren Quantenpunkte einen Bandabstand aufweisen, der größer als jener der ladungsträgerliefernden Quantenpunkte ist, und eine Bandausrichtung in Bezug auf die Bänder der ladungsträgerliefernden Quantenpunkte und der lichtemittierenden Quantenpunkte aufweisen, die Injektion von Elektronen oder von Löchern in die lichtemittierenden Quantenpunkte, jedoch nicht beides, begünstigt.

**5.** Lichtemittierende Vorrichtung nach einem der Ansprüche 1 bis 4, wobei die Konzentration der lichtemittierenden Quantenpunkte in der binären oder ternären Mischung im Bereich von 1 bis 20 Volumen-% liegt und die Konzentration der ladungsträgerliefernden Quantenpunkte in der binären oder ternären Mischung im Bereich von 80 bis 99 Volumen-%, vorzugsweise von 50 bis 99 Volumen-%, liegt.

**6.** Lichtemittierende Vorrichtung nach Anspruch 5, wenn abhängig von Anspruch 2, wobei die Konzentration der weiteren Quantenpunkte in der ternären Mischung im Bereich von 20 bis 50 Volumen-%, vorzugsweise von 30 bis 50 Volumen-%, liegt.

**7.** Lichtemittierende Vorrichtung nach einem der vorhergehenden Ansprüche, wobei die Wirtsmatrix einen elektrisch leitenden Perkolationspfad bildet, während die lichtemittierenden Quantenpunkte innerhalb der Wirtsmatrix so dispergiert sind, dass sie voneinander beabstandet und isoliert sind, dass sie keinen elektrisch leitenden Pfad bilden.

**8.** Lichtemittierende Vorrichtung nach einem der vorhergehenden Ansprüche, wobei die ladungsträgerliefernden Quantenpunkte Trägerdiffusionslängen von mehr als 10 nm für beide Typen von Ladungsträgern, Elektronen und Löcher, vorzugsweise in einem Bereich von 10 nm bis 500 nm, besitzen.

9. Lichtemittierende Vorrichtung nach einem der vorhergehenden Ansprüche, ferner umfassend:

   - eine Elektroneninjektions- und Lochsperrschicht (Ie), die zwischen der aktiven lichtemittierenden Schicht (A) und einer der ersten (E1) oder der zweiten (E2) Elektrode angeordnet ist, und
   - eine Lochinjektions- und Elektronensperrschicht (Ih), die zwischen der aktiven lichtemittierenden Schicht (A) und der anderen der ersten (E1) und der zweiten (E2) Elektrode angeordnet ist.

10. Lichtemittierende Vorrichtung nach Anspruch 9, wobei die Elektroneninjektions- und Lochsperrschicht (Ie) zwischen der aktiven lichtemittierenden Schicht (A) und der ersten Elektrode (E1) angeordnet ist und wobei die Lochinjektions- und Elektronensperrschicht (Ih) eine Halbleiterschicht ist, die einen Typ-II-Heteroübergang mit allen Quantenpunkten der aktiven lichtemittierenden Schicht (A) bildet.

11. Lichtemittierende Vorrichtung nach Anspruch 10, wobei die Lochinjektions- und Elektronensperrschicht (Ih) Quantenpunkte enthält.

12. Lichtemittierende Vorrichtung nach einem der vorhergehenden Ansprüche, wobei sowohl die ladungsträgerliefernden Quantenpunkte als auch die lichtemittierenden Quantenpunkte PbS-Quantenpunkte sind und/oder wobei die weiteren Quantenpunkte ZnO-Nanokristalle sind.

13. Lichtemittierende Vorrichtung nach einem der vorhergehenden Ansprüche, wobei die lichtemittierende Vorrichtung ausgebildet ist, Licht im Infrarotbereich, im nahen Infrarotbereich und/oder im kurzwelligen Infrarotbereich zu emittieren.

14. Optisches Spektrometer, umfassend die lichtemittierende Vorrichtung nach einem der vorhergehenden Ansprüche, zum Emittieren von Licht mit unterschiedlichen Wellenlängen auf einen Gegenstand, und wenigstens einen Photodetektor, der ausgebildet ist, um Licht mit irgendeiner der unterschiedlichen Wellenlängen zu detektieren.

15. Abwärtskonvertierender Film für eine lichtemittierende Vorrichtung, wobei der Abwärtskonvertierungsfilm konfiguriert und angeordnet ist, auf der Oberseite der lichtemittierenden Vorrichtung platziert zu werden, um dadurch emittiertes Licht zu absorbieren und abwärts zu konvertieren, und wobei er eine aktive lichtemittierende Schicht (A) enthält, die eine Wirtsmatrix und darin eingebettete lichtemittierende Quantenpunkte enthält, **dadurch gekennzeichnet, dass** die Wirtsmatrix ladungsträgerliefernde Quantenpunkte enthält, die mit den lichtemittierenden Quantenpunkten gemischt sind, eine binäre Mischung bilden, wobei die ladungsträgerliefernden Quantenpunkte dafür ausgebildet und angeordnet sind, den lichtemittierenden Quantenpunkten Ladungsträger zuzuführen, wobei die lichtemittierenden Quantenpunkte dafür ausgebildet und ausgelegt sind, die zugeführten Ladungsträger anzunehmen, und wobei die lichtemittierenden Quantenpunkte innerhalb der Wirtsmatrix homogen dispergiert und um mehr als 3 nm voneinander beabstandet sind.

**Revendications**

1. Dispositif électroluminescent comprenant :

   - un substrat ;
   - une première électrode (E1) formée par une première couche électriquement conductrice disposée sur ledit substrat ;
   - une couche active électroluminescente (A) disposée sur ladite première couche électriquement conductrice, et qui comprend une matrice hôte et des points quantiques électroluminescents incorporés à l'intérieur ; et
   - une deuxième électrode (E2) formée par une deuxième couche électriquement conductrice disposée sur ladite couche active électroluminescente (A) ;

   dans lequel ladite matrice hôte comprend des points quantiques fournisseurs de porteurs de charge mélangés avec lesdits points quantiques électroluminescents, formant un mélange binaire dans lequel les points quantiques fournisseurs de porteurs de charge sont fabriqués et disposés de manière à fournir des porteurs de charge aux points quantiques électroluminescents, dans lequel les points quantiques électroluminescents sont fabriqués et disposés de manière à accepter les porteurs de charge fournis, et **caractérisé en ce que** les points quantiques électroluminescents sont dispersés de manière homogène dans la matrice hôte et distants de plus de 3 nm les uns des autres.

2. Dispositif électroluminescent selon la revendication 1, dans lequel ladite matrice hôte comprend un mélange ternaire formé par ledit mélange binaire et d'autres points quantiques fabriqués et disposés de manière à passiver les pièges à électrons possibles des points quantiques électroluminescents et à équilibrer l'injection de porteurs de charge.

3. Dispositif électroluminescent selon la revendication 1 ou 2, dans lequel lesdits points quantiques fournisseurs de porteurs de charge sont plus petits que lesdits points quantiques électroluminescents, ont une bande interdite plus large et forment une hétérojonction de type I avec eux.

4. Dispositif électroluminescent selon la revendication 3 lorsqu'il dépend de la revendication 2, dans lequel lesdits autres points quantiques ont une bande interdite plus grande que celle des points quantiques fournisseurs de porteurs de charge, et un alignement de bande par rapport aux bandes des points quantiques fournisseurs de porteurs de charge et des points quantiques électroluminescents qui favorise l'injection d'électrons ou de trous dans les points quantiques électroluminescents, mais pas les deux à la fois.

5. Dispositif électroluminescent selon l'une quelconque des revendications 1 à 4, dans lequel la concentration des points quantiques électroluminescents dans le mélange binaire ou ternaire est comprise entre 1 % et 20 % en volume, et la concentration des points quantiques fournisseurs de charge dans le mélange binaire ou ternaire est comprise entre 80 % et 99 % en volume, de préférence entre 50 % et 99 % en volume.

6. Dispositif électroluminescent selon la revendication 5 lorsqu'il dépend de la revendication 2, dans lequel la concentration des autres points quantiques dans le mélange ternaire est comprise entre 20 % et 50 % en volume, de préférence entre 30 % et 50 %.

7. Dispositif électroluminescent selon l'une quelconque des revendications précédentes, dans lequel la matrice hôte forme un chemin de percolation électriquement conducteur, tandis que les points quantiques électroluminescents sont dispersés dans la matrice hôte à une distance telle et isolés les uns des autres qu'ils ne forment pas de chemin électriquement conducteur.

8. Dispositif électroluminescent selon l'une quelconque des revendications précédentes, dans lequel les points quantiques fournisseurs de porteurs de charge possèdent des longueurs de diffusion de porteurs supérieures à 10 nm pour les deux types de porteurs de charge, les électrons et les trous, de préférence dans une plage de 10 nm à 500 nm.

9. Dispositif électroluminescent selon l'une quelconque des revendications précédentes, comprenant en outre :

   - une couche d'injection d'électrons et de blocage de trous (Ie) disposée entre ladite couche active électroluminescente (A) et l'une desdites première (E1) et deuxième (E2) électrodes ; et
   - une couche d'injection de trous et de blocage d'électrons (Ih) disposée entre ladite couche active électroluminescente (A) et l'autre de ces première (E1) et deuxième (E2) électrodes.

10. Dispositif électroluminescent selon la revendication 9, dans lequel ladite couche d'injection d'électrons et de blocage de trous (Ie) est disposée entre la couche active électroluminescente (A) et la première électrode (E1), et dans lequel la couche d'injection de trous et de blocage d'électrons (Ih) est une couche semi-conductrice qui forme une hétérojonction de type II avec tous les points quantiques de la couche active électroluminescente (A).

11. Dispositif électroluminescent selon la revendication 10, dans lequel la couche semi-conductrice (Ih) injectant des trous et bloquant les électrons comprend des points quantiques.

12. Dispositif électroluminescent selon l'une quelconque des revendications précédentes, dans lequel les points quantiques fournisseurs de charge et les points quantiques électroluminescents sont des points quantiques PbS, et/ou dans lequel les autres points quantiques sont des nanocristaux de ZnO.

13. Dispositif électroluminescent selon l'une quelconque des revendications précédentes, dans lequel le dispositif électroluminescent est conçu pour émettre de la lumière infrarouge, proche infrarouge et/ou infrarouge à ondes courtes.

14. Spectromètre optique, comprenant le dispositif électroluminescent selon l'une quelconque des revendications précédentes, pour émettre de la lumière avec différentes longueurs d'onde sur un objet, et au moins un photodétecteur conçu pour détecter la lumière avec n'importe laquelle de ces différentes longueurs d'onde.

15. Film de conversion à la baisse pour un dispositif électroluminescent, où le film de conversion à la baisse est configuré et arrangé pour être placé sur ledit dispositif électroluminescent pour absorber et convertir à la baisse la lumière émise par celui-ci, et dans lequel il comprend une couche active électroluminescente (A) qui comprend une matrice hôte et des points quantiques électroluminescents incorporés à l'intérieur, **caractérisés en ce que** ladite matrice hôte comprend des points quantiques fournisseurs de porteurs de charge mélangés avec lesdits points quantiques électroluminescents, formant un mélange binaire dans lequel les points quantiques fournisseurs de porteurs de charge sont fabriqués et disposés de manière à fournir des porteurs de charge aux points quantiques électroluminescents, dans lequel les points quantiques électroluminescents sont fabriqués et disposés de manière à accepter les porteurs de charge fournis, et dans lequel les points quantiques électroluminescents sont dispersés de manière homogène dans la matrice hôte et sont distants de plus de 3 nm les uns des autres.

Fig. 1

Fig. 2

**Fig. 3**

Fig. 4

Fig. 5

Fig. 6

**Fig. 7**

**Fig. 8**

**Fig. 9**

Fig. 10

Fig. 11

**Fig. 12**

**Fig. 13**

Fig. 14

Fig. 15

**Fig. 16**

**Fig. 17a**

## Fig. 17b

## Fig. 17c

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 2212398 B1

- US 2010270511 A1

**Non-patent literature cited in the description**

- **KONSTANTATOS, G. et al.** Ultrasensitive solution-cast quantum dot photodetectors. *Nature,* 2006, vol. 442, 180-183
- **SARGENT, E. H.** Colloidal quantum dot solar cells. *Nat. Photonics,* 2012, vol. 6, 133-135
- **LIU, M. et al.** Hybrid organic-inorganic inks flatten the energy landscape in colloidal quantum dot solids. *Nat. Mater.,* 2017, vol. 16, 258-263
- **ANIKEEVA, P. O. ; HALPERT, J. E. ; BAWENDI, M. G. ; BULOVIC', V.** Quantum dot light-emitting devices with electroluminescence tunable over the entire visible spectrum. *Nano Lett.,* 2009, vol. 9, 2532-2536
- **PAL, B. N. et al.** Giant' CdSe/CdS core/shell nanocrystal quantum dots as efficient electroluminescent materials: strong influence of shell thickness on light-emitting diode performance. *Nano Lett.,* 2012, vol. 12, 331-336
- **HINES, M. A. ; SCHOLES, G. D.** Colloidal PbS nanocrystals with size-tunable near-infrared emission: observation of post-synthesis self-narrowing of the particle size distribution. *Adv. Mater.,* 2003, vol. 15, 1844-1849
- **MASHFORD, B. S. et al.** High-efficiency quantum-dot light-emitting devices with enhanced charge injection. *Nat. Photonics,* 2013, vol. 7, 407-412
- **DAI, X. et al.** Solution-processed, high-performance light-emitting diodes based on quantum dots. *Nature,* 2014, vol. 515, 96-99
- **SUPRAN, G. J. et al.** High-performance shortwave-infrared light-emitting devices using core-shell (PbS-CdS) colloidal quantum dots. *Adv. Mater.,* 2015, vol. 27, 1437-1442
- **BOREK, C. et al.** Highly efficient, near-infrared electro phosphorescence from a Pt-metalloporphyrin complex. *Angew. Chem.,* 2007, vol. 46, 1109-1112
- **GOOSSENS, S. et al.** Broadband image sensor array based on graphene-CMOS integration. *Nat. Photonics,* 2017, vol. 11, 366-371
- **MURPHY, C. J.** Optical sensing with quantum dots. *Anal. Chem.,* 2002, vol. 74, 520A-526A

- **MEDINTZ, I. L. ; UYEDA, H. T. ; GOLDMAN, E. R. ; MATTOUSSI, H.** Quantum dot bio conjugates for imaging, labelling and sensing. *Nat. Mater.,* 2005, vol. 4, 435-446
- **VOURA, E. B. ; JAISWAL, J. K. ; MATTOUSSI, H. ; SIMON, S. M.** Tracking early metastatic progression with quantum dots and emission scanning microscopy. *Nat. Med.,* 2004, vol. 10, 993-998
- **PARK, S. I. et al.** Soft, stretchable, fully implantable miniaturized optoelectronic systems for wireless optogenetics. *Nat. Biotechnol.,* 2015, vol. 33, 1280-1286
- **KIM, J. et al.** Battery-free, stretchable optoelectronic systems for wireless optical characterization of the skin. *Sci. Adv.,* 2016, vol. 2, e1600418
- **LOPEZ, A ; ARAZURI, S. ; GARCIA, I. ; MANGADO, J. ; JAREN, C.** A review of the application of near-infrared spectroscopy for the analysis of potatoes. *J. Agric. Food Chem.,* 2013, vol. 61, 5413-5424
- **SUN, L. et al.** Bright infrared quantum-dot light-emitting diodes through inter-dot spacing control. *Nat. Nanotechnol.,* 2012, vol. 7, 369-373
- **YANG, Z. et al.** All-quantum-dot infrared light-emitting diodes. *ACS Nano,* 2015, vol. 9, 12327-12333
- **GONG, X. et al.** Highly efficient quantum dot near-infrared light-emitting diodes. *Nat. Photonics,* 2016, vol. 10, 253-257
- **BOURDAKOS, K. N. ; DISSANAYAKE, D. M. N. M. ; LUTZ, T. ; SILVA, S. R. P. ; CURRY, R. J.** Highly efficient near-infrared hybrid organic-inorganic nanocrystal electroluminescence device. *Appl. Phys. Lett.,* 2008, vol. 92, 153311
- **YANG, X. et al.** Iodide capped PbS/CdS core-shell quantum dots for efcient long wavelength near-infrared lightemitting diodes. *Sci. Reports,* 2017, vol. 7, 14741
- **COLVIN, V. L ; SCHLAMP, M. C. ; ALIVISATOS, A. P.** Light-emitting diodes made from cadmium selenide nanocrystals and a semiconducting polymer. *Nature,* 1994, vol. 370, 354-357

- **TESSLER, N. ; MEDVEDEV, V. ; KAZES, M. ; KAN, S. ; BANIN, U.** Efficient near-infrared polymer nanocrystal light-emitting diodes. *Science,* 2002, vol. 295, 1506-1508
- **KONSTANTATOS, G. ; HUANG, C. ; LEVINA, L. ; LU, Z. ; SARGENT, E. H.** Efficient infrared electroluminescent devices using solution-processed colloidal quantum dots. *Adv. Func. Mater.,* 2005, vol. 15, 1865-1869
- **ROY CHOUDHURY ; K., SONG ; D. W. ; SO, F.** Efficient solution-processed hybrid polymer-nanocrystal near infrared light-emitting devices. *Org. Electron.,* 2010, vol. 11, 23-28
- **RATH, A. K. et al.** Remote trap passivation in colloidal quantum dot bulk nano-heterojunctions and its effect in solution-processed solar cells. *Adv. Mater.,* 2014, vol. 26, 4741-4747
- **PRADHAN, S. ; STAVRINADIS, A. ; GUPTA, S. ; CHRISTODOULOU, S. ; KONSTANTATOS, G.** Breaking the open-circuit voltage deficit floor in pbs quantum dot solar cells through synergistic ligand and architecture engineering. *ACS Energy Lett.,* 2017, vol. 2, 1444-1449
- **CAREY, G. H. ; LEVINA, L. ; COMIN, R. ; VOZNYY, O. ; SARGENT, E. H.** Record charge carrier diffusion length in colloidal quantum dot solids via mutual dot-to-dot surface passivation. *Adv. Mater.,* 2015, vol. 27, 3325-3330
- **ZHITOMIRSKY, D. et al.** Engineering colloidal quantum dot solids within and beyond the mobility-invariant regime. *Nat. Commun.,* 2014, vol. 5, 3803
- **BI, Y. et al.** Infrared solution-processed quantum dot solar cells reaching external quantum efficiency of 80% at 1.35 $\mu$m and JSC in excess of 34 mA cm. *Adv. Mater.,* 2018, vol. 30, 1704928
- **PRADHAN, S. et al.** Trap-state suppression and improved charge transport in pbs quantum dot solar cells with synergistic mixed-ligand treatments. *Small,* 2017, vol. 13, 1700598
- **QIAN, L. et al.** Electroluminescence from light-emitting polymer/ZnO nanoparticle heterojunctions at sub-bandgap voltages. *Nano Today,* 2010, vol. 5, 384-389
- **JI, W. et al.** The work mechanism and sub-bandgap-voltage electroluminescence in inverted quantum dot light-emitting diodes. *Sci. Reports,* 2014, vol. 4, 6974
- **LI, J. et al.** Single-layer halide perovskite light-emitting diodes with sub-band gap turn-on voltage and high brightness. *J. Phys. Chem. Lett.,* 2016, vol. 7, 4059-4066
- **NAGPAL, P. ; KLIMOV, V. I.** Role of mid-gap states in charge transport and photoconductivity in semiconductor nanocrystal films. *Nat. Commun.,* 2011, vol. 2, 486
- **BAE, W. K. et al.** Controlling the influence of Auger recombination on the performance of quantum-dot light-emitting diodes. *Nat. Commun.,* 2013, vol. 4, 2661
- **CAO, Y. ; STAVRINADIS, A. ; LASANTA, T. ; SO, D. ; KONSTANTATOS, G.** The role of surface passivation for efficient and photostable PbS quantum dot solar cells. *Nat. Energy,* 2016, vol. 1, 16035
- **ZHITOMIRSKY, D. ; VOZNYY, O. ; HOOGLAND, S. ; SARGENT, E. H.** Measuring charge carrier diffusion in coupled colloidal quantum dot solids. *ACS Nano,* 2013, vol. 7, 5282-5290
- **RAU, U.** Reciprocity relation between photovoltaic quantum efficiency and electroluminescent emission of solar cells. *Phys. Rev. B,* 2007, vol. 76, 085303
- **YAO, J. et al.** Quantifying losses in open-circuit voltage in solution-processable solar cells. *Phys. Rev. Applied,* 2015, vol. 4, 014020
- **TRESS, W.** Perovskite solar cells on the way to their radiative efficiency limit - insights into a success story of high open-circuit voltage and low recombination. *Adv. Energy Mater.,* 2017, vol. 7, 1602358
- **CHUANG, C. -H. M. et al.** Open-circuit voltage deficit, radiative sub-bandgap states, and prospects in quantum dot solar cells. *Nano Lett.,* 2015, vol. 15, 3286-3294
- **WALTER, T. ; HERBERHOLZ, R. ; MÜLLER, G. ; SCHOCK, H. W.** Determination of defect distributions from admittance measurements and application to Cu(In,Ga)Se2 based heterojunctions. *J. Appl. Phys.,* 1996, vol. 80, 4411
- **BOZYIGIT, D. ; VOLK, S. ; YAREMA, O. ; WOOD, V.** Quantification of deep traps in nanocrystal solids, their electronic properties, and their influence on device behavior. *Nano Lett.,* 2013, vol. 13, 5284-5288
- **LEE, J. W. ; KIM, D. Y. ; BAEK, S. ; YU, H. ; SO, F.** Inorganic UV-Visible-SWIR broadband photodetector based on monodisperse PbS nanocrystals. *Small,* 2016, vol. 12, 1328-1333
- **MELLO, J. C. ; WITTMANN, H. F. ; FRIEND, R. H.** An improved experimental determination of external photoluminescence quantum efficiency. *Adv. Mater.,* 1997, vol. 9, 230-232
- **JIN, Z. ; WANG, A. ; ZHOU, Q. ; WANG, Y. ; WANG, J.** Detecting trap states in planar PbS colloidal quantum dot solar cells. *Sci. Reports,* 2016, vol. 6, 37106